# EUROPEAN PATENT APPLICATION

(11) **EP 4 831 593 A1**
(43) Date of publication of application: **28.10.2026**
(21) Application number: 26172330.8
(22) Date of filing: 14.04.2026
(51) Int. Cl.: G01D 5/20, G10H 1/055, H03K 17/95, H03K 17/972

(54) **TWO-DIMENSIONAL POSITION SENSING SYSTEM**

(30) Priority: 14.04.2025 GB 202505591
(71) Applicant: Sonuus Limited, Farnborough Hampshire GU14 7NA (GB)
(72) Inventor: CLARK, James Hastings, Farnborough, GU14 7NA (GB)
(74) Representative: Marks & Clerk LLP

(57) **Abstract**

A sensing system for detecting position and/or movement, the system comprising: at least one active resonant circuit each having a sensing coil for emitting an RF signal, each sensing coil comprising a set of at least one turn about an axis; and a passive circuit having a target coil for receiving RF energy from each said sensing coil, the target coil comprising a set of at least one turn about an axis, wherein, for each said active resonant circuit,: at least one of the passive circuit and the active resonant circuit is configured to, when the active resonant circuit is driven and the axes of the target coil and sensing coil remain substantially parallel, output a signal dependent on an extent of overlap of the target coil and the sensing coil of the active resonant circuit, to thereby indicate a relative position and/or movement of the target and sensing coils, wherein the indicated relative position and/or movement is substantially within a range of relative positions having at least one limit comprising: a first relative position wherein a first said axis that is of a first said coil is aligned with an outermost edge of a side of the turn set of a second said coil; and/or a second relative position wherein the first axis is aligned with an innermost edge on the side of the turn set of the second coil, wherein the first coil and the second coil comprise the target coil and the sensing coil.

## Description

### FIELD OF THE INVENTION

This invention generally relates to a sensing system for detecting position and/or movement, an actuator comprising the sensing system, a piano key in the form of the actuator, a keyboard comprising a plurality of the actuators, and a musical instrument having the actuator.

### BACKGROUND TO THE INVENTION

Musical keyboards for electronic instruments generally use a switch or similar contacting device to sense a single striking position of a key. The closing of the switch is used to detect a note-on event and the opening of the switch is used to detect a note-off event. In this regard, and in comparison to purely mechanical switches and pressure sensors, resonant sensors that employ an inductive coil for sensing are known to have many advantages.

A resonant sensor for sensing a key actuation generally comprises a measurement circuit to detect a relative position and/or movement between an active resonant circuit and a passive resonant load. Drive electronics drive the active circuit to generate an RF signal at a resonant frequency of the active circuit. An output generated by the active circuit is however dependent on energy transfer from the active circuit to the passive load via the RF signal. Such sensing may for example allow improved reliability, precision, accuracy, and/or low cost

There nevertheless remains a need for enhanced measurement or detection of user contact to a key and/or new effect(s), such as new musical effects of a piano or other musical instrument. Additional and/or alternative desired enhancements include, inter alia, reduced electrical power requirements, reduced EMI emissions, greater accuracy, increased sensor output reproducibility, and/or increased sensor speed for example to allow faster scan rates.

For use in understanding the present invention, the following disclosures are referred to:
- GB2494183 A and GB2494230 A (Clark et al; each published 6.3.13), each relating to a musical effect controller with a position sensor comprising a tuned resonant circuit;
- GB2569578 A (Clark et al; published 26.6.19) relating to keyboard sensor systems and methods;
- WO/2019/122867 A1 (Clark et al; published 27.6.19) relating to keyboard sensor systems and methods;
- GB2570533 A and WO/2020/030912 A1 (Clark et al; published 31.7.19 and 13.2.20) each relating to keyboard sensor systems and methods;
- GB2576610 A (Clark et al; published 26.2.20) relating to electronic drums;
- GB2578346 A and WO2020/030911 A1 (Clark et al; published 6.5.20 and 13.2.20) relating to computer input devices;
- GB 2610369 A and WO/2022/258474 A1 (Clark et al; published 8.3.23 and 15.12.22) relating to a position or movement sensing system.

### SUMMARY

According to an aspect of the present invention, there is provided a sensing system for detecting position and/or movement, the system comprising: at least one active resonant circuit each having a sensing coil for emitting an RF signal, each sensing coil comprising a set of at least one turn about an axis; and a passive circuit having a target coil for receiving RF energy from each said sensing coil, the target coil comprising a set of at least one turn about an axis, wherein, for each said active resonant circuit,: at least one of the passive circuit and the active resonant circuit is configured to, when the active resonant circuit is driven and the axes of the target coil and sensing coil remain substantially parallel, output a signal dependent on an extent of overlap of the target coil and the sensing coil of the active resonant circuit, to thereby indicate a relative position and/or movement of the target and sensing coils, wherein the indicated relative position and/or movement is substantially within a range of relative positions having at least one limit comprising: a first relative position wherein a first said axis that is of a first said coil is aligned with an outermost edge on a side of the turn set of a second said coil; and/or a second relative position wherein the first axis is aligned with an innermost edge on the side of the turn set of the second coil, wherein the first coil and the second coil comprise the target coil and the sensing coil.

(Merely for completeness regarding the above term 'substantially', it is noted that this term may mean 'exactly' or 'approximately' at any instance throughout this specification).

Advantageously, variation of an output signal (preferably from an active circuit) in an embodiment may allow lateral position and/or movement detection, in addition to any axial detection if the active circuit and the passive circuit are moved axially forward and/or away from each other. For lateral detection, the position variation within the range generally may involve the first and second axes moving into and/or out of alignment to vary the overlap between the coils. The overlap variation may vary between e.g. full and no overlap of respective sides of target and sensing turn sets. In preferred embodiments, the first axis is of the target coil and thus referred to as a target axis that moves towards, into, away from and/or out of alignment with the each of the edges of the second coil that is referred to as a sensing coil. However, in other embodiments the first axis is of a sensing coil and the second axis is of a target coil. Regardless, the limited range on which the detections are based may allow an output signal to vary monotonically with correspondingly varying lateral separation of the active and passive coils. Such output signal variation may also vary monotonically with varying axial separation. **In** different embodiments, monotonic variations with axial and lateral movement may be seen when axial and lateral separations are varied independently or at the same time. It is further noted that any limit of the relative position range may be implemented physically by component(s) that block relative movement of the coils beyond the limit. Additionally or alternatively, any limit may be implemented electronically, e.g. wherein output signals generated for a relative position beyond the limit are electronically inhibited and/or disregarded during signal processing and thus not used for any determination of a position and/or movement.

Regardless, the set of turns of any of the coils may comprise only one turn. This may for example mean that the innermost and outermost edge of the second coil are at the same turn. On the other hand, in embodiments wherein there is no gap around which the turns of the second, e.g. active or sensing, coil turn/wind, the innermost edge of the turn set may be at the axis of that coil. The axis of the first coil and/or that of the second axis is preferably a central axis extending through the coil, which may comprise one ore more preferably planar sets of turns.

**In** preferred embodiments, the passive circuit comprises a passive resonant circuit, preferably wherein the passive resonant circuit has a resonant frequency substantially equal to, a resonant frequency of at least one of the active resonant circuit(s).

There may further be provided the sensing system, wherein the axis of the second coil is a second axis extending, preferably substantially centrally, between the inner edge and the outer edge of the turn set of the second coil, the range comprising: an intermediate relative position wherein the first axis is aligned within the second axis.

There may further be provided the sensing system, wherein the first axis extends substantially centrally through the turn set of the first coil.

There may further be provided the sensing system configured to, while the first and second coils face each other with a fixed relative separation in an axial direction, provide a said output signal varying substantially monotonically with a monotonic change of the relative position in a lateral direction that is substantially perpendicular to the axial direction. **In** this case, any axial position and/or movement detection is preferably detected based on output signal(s) generated at different times compared to the output signal(s) used for the lateral detection.

There may further be provided the sensing system configured to, while the first and second coils have a fixed relative separation in the lateral direction, provide a said output signal varying substantially monotonically with a monotonic change of the relative position in the axial direction.

There may further be provided the sensing system, comprising at least one measurement circuit to generate a measurement signal indicating a position and/or movement, the at least one measurement circuit configured to: generate an axial measurement signal, based on a said output signal varying substantially monotonically with a monotonic change of the relative position in the axial direction at a first time; and generate a lateral measurement signal, based on a said output signal varying substantially monotonically with a monotonic change of the relative position in the lateral direction at another, second time. Such an embodiment may provide non-simultaneous axial and non-axial detection. Thus, if lateral and axial directions are referred to as X and Y directions respectively, the position and/or movement directions for the X and Y directions may be fully independent.

There may further be provided the sensing system, wherein the target coil and/or each sensing coil are planar coils each comprising at least one planar spiral. In this regard, any spiral referred to herein may be formed as a track such as on a printed circuit board (PCB). Furthermore, any sensing and target coil of an embodiment may comprise multiple planar spirals formed as tracks on respective conductive layers of a PCB, wherein the formed tracks of each spiral are preferably electrically connected by at least one via through one or more intervening layers of the PCB.

There may further be provided the sensing system, comprising a sensor having the at least one active resonant circuit and the passive circuit, wherein the at least one active resonant circuit comprises a pair of said active resonant circuits, wherein each of the pair has a said sensing coil comprising multiple said sets of turns, each said set comprising a spiral, wherein the spirals of the sensing coils of respective ones of the pair of active resonant circuits are interleaved. A notable advantage of such an embodiment may be to improve or allow lateral and axial position and/or movement, e.g., for X and Y coordinates or vectors, to be measured based on simultaneous output signals. Each such measurement may be based on output signals from both of the paired active resonant circuits.

There may further be provided the sensing system, wherein the interleaved spirals of respective said sensing coils are on opposite sides of an intermediate insulating layer such as a printed circuit board core, wherein: on a first side of the intermediate insulating layer, a region of a said spiral of a first said sensing coil is between the intermediate insulating layer and a region of a said spiral of a second said sensing coil, the regions of said spirals to thereby overlap; and on an opposite side of the intermediate insulating layer, a region of another said spiral of the first sensing coil is between the intermediate insulating layer and a region of another said spiral of the second sensing coil, the regions of said spirals to thereby overlap. Preferably, each overlap involves a full side of a set of turns of a spiral facing a full side of a set of turns of the facing spiral, so that no turn of either spiral is outside the overlap.

There may further be provided the sensing system, the sensing system comprising measurement circuitry for indicating axial and lateral positions and/or movement, wherein each said lateral position and/or movement is relative between: a target axis that is a said axis of the target coil; and a sensing axis that is a said axis of a sensing coil of the pair of active resonant circuits, the sensing axis extending, preferably substantially centrally, between the inner edge and the outer edge of an overlap region of the turn sets of the interleaved spirals, wherein the measurement circuitry is configured to perform the indicating for a range of relative positions of the target axis and sensing axis, wherein the range is within: - a first relative position wherein the target axis is aligned with a first edge of the overlap region; and - a second relative position wherein the target axis is aligned with an opposite edge of the overlap region,
preferably wherein the range comprises an intermediate relative position wherein the target axis is aligned with the sensing axis.

There may further be provided the sensing system, wherein the measurement circuitry is configured to indicate the axial and lateral positions based on said output signals received substantially simultaneously from respective ones of the pair of active resonant circuits.

There may further be provided the sensing system, configured to: generate a lateral position and/or movement indicator by subtracting a said measurement of a said output signal from one of a said pair of active resonant circuits from a said measurement of a said output signal from the other one of the pair. Such generation of the indicator may be performed by a processor, e.g., on a PCB having the coils or on a computer receiving the measurements preferably converted to digital format.

There may further be provided the sensing system, configured to: generate an axial position and/or movement indicator by adding a said measurement of a said output signal from one of a said pair of active resonant circuits from a said measurement of a said output signal from the other one of the pair. Similarly as for the above generation involving subtraction, the generation involving addition may be performed by a processor, e.g., on a PCB having the coils or on a computer receiving the measurements preferably converted to digital format.

There may further be provided the sensing system, configured to generate a two-dimensional position and/or movement indicator based on a said lateral indicator and a said axial indicator, and configured to generated said lateral and axial indicators based on the same said measurements of output signals from the active resonant circuits of a said pair. The 2-D indicator may be for example a coordinate or vector, for example an (x,y) coordinate.

There may further be provided the sensing system, configured to perform a calibration process and to indicate a relative position and/or movement of the target and sensing coils, wherein the calibration process comprises determining an output response, *F*(*x, y*)*,* of each of the active resonant circuits of the pair, the determined output responses comprising an output response *F1(x, y),* of a first of the active resonant circuits and an output response *F2(x, y)* of the other, second active resonant circuit, wherein at least the determining of the output response *F*1(*x,y*) is a determination procedure comprising: measuring a said output signal from the active resonant circuit at different lateral separations, x, while axial separation, y, is constant, to thereby generate a lateral response, *f*(*x*); measuring a said output signal from the active resonant circuit at different axial separations, y, while lateral separation, x, is constant, to thereby generate an axial response, g(y); determining a lateral sensitivity, S(y), according to *S(y) =* 1 *- g(y);* and determining the output response, *F(x,y),* according to *F(x,y) = f*(*x*) ** S*(*y*) *+ D * (1 - S(y)),* where D is a reference signal output value at an axial separation, wherein the determining of the output response *F2(x,y)* is based on:
- performing the determination procedure for the other, second active resonant circuit; or
- determining *F2(x,y)* as a reverse response, *F(-x,y),* that is a reversal of *F*1(*x,y*) about *x =* 0,
wherein the indication of the relative position and/or movement is performed by determining: an approximation of axial separation, y, based on y = *F*1(*x,y*) *+ F2(x,y);* and/or an approximation of lateral separation, *x,* based on *x = F1(x, y) - F*2(*x,y*)*.*

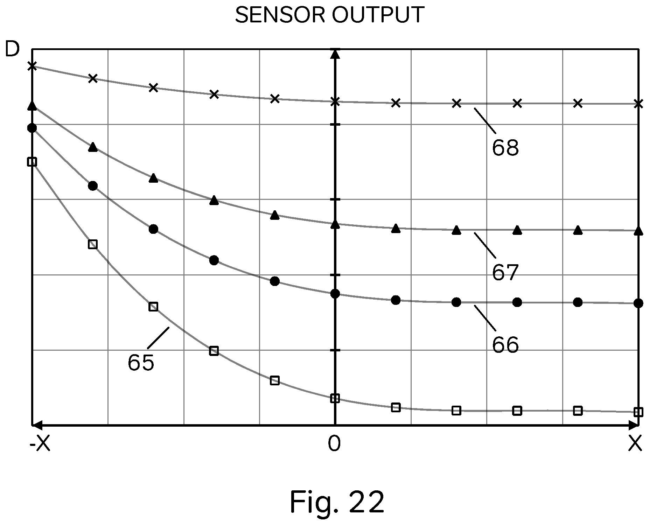

The above-mentioned reference value D may be a signal output value that would be output from the active resonant circuit in the absence of the passive circuit or at least in the absence of the target coil. D is therefore shown in Fig. 22, merely for purposes of illustration, as being at the highest level on the vertical axis, this level not being reached by any of the responses 65 - 68. Practically speaking, the maximum value D may never be measured in the presence of the passive circuit or target coil of an embodiment. Therefore, the value of D may be a value determined by measurements during assembly, before the passive circuit or target coil is added to the system under assembly. Alternatively, the value of D may be a predetermined reference value, for example estimated based on experience and/or measurements of related practical implementations of the system.

It is however noted that the calibration procedure may not be performed. Instead, a default, stored and/or preset F1(x,y) and/or F2(x,y) may be used to perform the indication of the relative position and/or movement using such approximation(s) based on the sum and/or difference of the F1 (x,y) and/or F2(x,y).

There may further be provided the sensing system, wherein the indication of the relative position and/or movement comprises determining the axial separation based on a function *H(x):* $H \left(x\right) = \frac{difference}{sum - 2 D}$ wherein the difference is *F*1(*x,y*) *- F2(x, y)* and the sum is *F1(x, y)* + F2(x, y).

There may further be provided the sensing system, configured to: drive the active resonant circuits of a said pair one at a time; and/or operate subsets of multiple said pairs of active resonant circuits one at a time, preferably wherein each said subset is one said pair. Any such 'one at a time' driving may be performed using a controller to control selection and/or scanning of each active resonant circuit or subset. Such selection and/or scanning may in effect implement Time Division Multiplexing. This may be of advantage for example to reduce interference.

There may further be provided the sensing system, comprising conductive layers wherein each said sensing coil of the pair has a said interleaved spiral in a respective said layer, wherein: at least one of the conductive layers has a ground loop surrounding the interleaved spiral on that layer and a said interleaved spiral of the pair that is in another said conductive layer. Preferably, the conductive layers, which have such loops for connecting to a fixed potential such as a ground potential, are of a multi-layer PCB. Each group may 'surround' the interleaved spirals at least in plan view, e.g., when viewed along a direction parallel to the axes through the spirals.

There may further be provided the sensing system, wherein the interleaved spirals of a said pair of active resonant circuits overlap the interleaved spirals of another pair of active resonant circuits, preferably wherein each said pair comprises at least one said ground loop surrounding a said spiral of each of the sensing conductive coils of the pair, the group loop in a plane between and not comprising any said spirals of the pair.

There may further be provided the sensing system, wherein: the active resonant circuits of a said pair have offset resonant frequencies; and/or the passive circuit comprises a pair of preferably substantially co-located passive resonant circuits each for inductively receiving energy from a respective one of the pair of active resonant circuits, wherein each of the passive resonant circuits has a resonant frequency that is substantially the same as the resonant frequency of each of the active resonant circuits of the pair; and/or the system is configured to provide drive signals to drive respective active resonant circuits of the pair, the drive signals having different drive frequencies.

There may further be provided the sensing system, wherein a said active resonant circuit comprises: an output mute switch coupled to an output line of the sensing coil; and preferably an input mute switch coupled to an input line of the sensing coil, wherein each said mute switch is configured to apply a fixed voltage to the coupled line when the active resonant circuit is undriven and/or is to be idle.

It is further noted that each active resonant circuit generally has an input line for connection to a driver. A resistive element may be provided in any such line, in embodiments to resist current flow from the driver to the active resonant circuit. In some embodiments such a resistive element may however may be shared by multiple ones of the active resonant circuits.

There may further be provided the sensing system, wherein the at least one active resonant circuit comprises multiple said active resonant circuits each having a said output mute switch and preferably the input mute switch, the sensing system configured to selectively drive one of the active resonant circuits at a time to emit an RF signal, and to control at least a said output mute switch of each undriven active resonant circuit to apply the fixed voltage.

In some embodiments, the sensing system comprises a measurement circuit to generate a measurement signal representing an amplitude or phase of at least one said output signal, wherein the measurement circuit comprises: a synchronous demodulator circuit to generate the measurement signal; an amplitude-sensitive demodulator circuit to generate the measurement signal; and/or a sample-and-hold circuit to output the measurement signal. In this case, and if the at least one active resonant circuit comprises multiple such active resonant circuits each having an output line, the system may comprise a multiplexer that is selectively controllable to couple each output line of the multiple active resonant circuits to the measurement circuit. It is further noted that the measurement signal representing the amplitude or phase generally has a voltage level proportional to a said amplitude or phase. Preferably, the sensing system comprises an analogue-to-digital converter to convert any or all measurement signal(s) to therefore provide a digital active circuit output. It is still further noted that, additionally or alternatively to the above multiplexer, an embodiment may comprise an input multiplexer to selectively provide drive signals to active circuits, for example in embodiments where individual or sub-groups of active circuits are not needed to be driven simultaneously.

There is further provided an actuator comprising the sensing system, the actuator having: a first member having at least the sensing coil of at least one said active resonant circuit; and a second member having at least the target coil of a said passive circuit, wherein the first and second members face each other in an axial direction, and wherein at least one of the first and second members is movable in at least a lateral direction relative to the other of the first and second members, the lateral direction substantially perpendicular to the axial direction, preferably wherein at least one of the first and second members is movable in the axial direction relative to the other of the first and second members.

There may further be provided the actuator, wherein at least one of: the first member comprises an electrically conductive material and an electrically insulating spacer, such as an air gap, between the electrically conductive material and at least one said sensing coil; and/or the second member comprises an electrically conductive material and an electrically insulating spacer, such as an air gap, between the electrically conductive material and at least the target coil.

There is further provided a piano key in the form of the actuator.

There is further provided a keyboard comprising a plurality of the actuators, preferably wherein the actuator comprises multiple said first members each having a said sensing coil, each of the multiple first members moveable in at least the lateral direction relative to a said second member in common.

There is further provided a musical instrument having the actuator or the keyboard.

According to another aspect of the present invention, there is provided a method of detecting position and/or movement, the system comprising: driving an active resonant circuit to emit an **RF** signal from a sensing coil of the active resonant circuit, the sensing coil comprising a set of at least one turn about an axis; receiving, by a target coil of a passive circuit, energy from the emitted **RF** signal, the target coil comprising a set of at least one turn about an axis; outputting at least one signal from the active resonant circuit during the **RF** emission, each at least one signal dependent on resonance of the active resonant circuit; and determining a relative position and/or movement of the target and sensing coils based on one or more said signals that are outputted when a relative position of the target and sensing coils is substantially within a range having at least one limit comprising: a first relative position wherein a central axis of the target coil is aligned with an outermost turn on a side of the sensing coil; and/or a second relative position wherein the central axis of the target coil is aligned with an innermost the turn on the side of the sensing coil.

Preferred embodiments are defined in the appended dependent claims.

Any one or more of the above aspects and/or any one or more of the above optional, i.e., preferable, features of the preferred embodiments may be combined, in any permutation.

The invention further provides processor control code to implement the above-described aspects, for example on a general purpose computer system or on a digital signal processor (DSP). According to a related aspect of the invention, there is provided a non-transitory data carrier carrying processor control code which, when running on a processor, causes the processor to implement one or more steps of the invention. The invention may comprise a controller which includes a microprocessor, working memory and program memory coupled to one or more of the components of the system. The or each processor may be implemented in any known suitable hardware such as a microprocessor, a Digital Signal Processing (DSP) chip, an Application Specific Integrated Circuit (ASIC), Field Programmable Gate Arrays (FPGAs), etc. The or each processor may have connectivity to a bus to execute instructions and process information stored in, for example, a memory.

### BRIEF DESCRIPTION OF THE DRAWINGS

For a better understanding of the invention and to show how the same may be carried into effect, reference will now be made, by way of example, to the accompanying drawings, in which:
Fig. 1 shows an example active tuned resonant circuit for use in embodiments.
Fig. 2 shows an example passive tuned resonant circuit for use in embodiments.
Fig. 3 shows an example of a simple measurement, e.g. read-out, circuit comprising a synchronous demodulator which may be used in embodiments.
Fig. 4 shows an example of a simple measurement, e.g. read-out, circuit comprising an amplitude-sensitive demodulator which may be used in embodiments.
Fig. 5 shows an example of a simple measurement, e.g., read-out, circuit comprising an amplitude-sensitive demodulator with a sample-and-hold function which may be used in embodiments.
Fig. 6A shows (a1) an example printed circuit design, on an enlarged scale, for a passive tuned resonant circuit for use in embodiments, with (a2) a schematic representation thereof.
Fig. 6B shows (b1) an example printed circuit design, on an enlarged scale, for an active tuned resonant circuit for use in embodiments, with (b2) a schematic representation thereof.
Fig. 7 shows an axis of relative Y displacement of a passive tuned resonant circuit from an active tuned resonant circuit.
Fig. 8 shows an example normalised output from a sensor comprising an active tuned resonant circuit and a read-out electronic circuit as a passive tuned resonant circuit is displaced , relative to an active tuned resonant circuit, along the Y axis of Fig. 7.
Fig. 9 shows an axis of relative X displacement of a passive tuned resonant circuit from an active tuned resonant circuit.
Fig. 10 shows an example normalised output from a sensor comprising an active tuned resonant circuit and a read-out electronic circuit as a passive tuned resonant circuit is displaced, relative to an active tuned resonant circuit, along the X axis of Fig. 9.
Fig. 11 shows an example printed circuit design, on an enlarged scale, for an interleaved pair of inductive coils of an active sensor pair for use in embodiments, with a schematic representation thereof.
Fig. 12 shows axes of relative X and Y displacements of a passive tuned resonant circuit from an active sensor pair according to embodiments.
Fig. 13 shows an example normalised output from an active sensor pair as a passive tuned resonant circuit is displaced along the X axis of Fig. 12.
Fig. 14 shows an active tuned resonant circuit with muting transistors for use in embodiments.
Fig. 15 shows an example printed circuit design, on an enlarged scale, for a plurality of interleaved pairs of inductive coils, each surrounded by grounded traces, for use in embodiments.
Fig. 16 shows an example printed circuit design, on an enlarged scale, for a plurality of interleaved pairs of inductive coils, each surrounded by grounded traces, for use in embodiments, with a schematic representation thereof.
Fig. 17 shows a time division multiplex circuit diagram of a preferred embodiment used to multiplex a plurality of active tuned resonant circuits according to Fig. 14 to determine the X and Y position of a plurality of sensing elements.
Fig. 18 shows a cross-section view of an example actuator of a musical instrument such as the actuator of Fig. 19, wherein at least the Y position of the actuator is determined using an embodiment.
Fig. 19 shows a plan view of an example actuator of a musical instrument, such as the actuator of Fig. 18, wherein at least the X position of the actuator is determined using an embodiment.
Fig. 20 shows an example printed circuit design, on an enlarged scale, for interleaved pairs of inductive coils of active sensor pairs with different lateral positions of passive tuned resonant circuits overlaid.
Fig. 21 shows a block diagram of an example sensing system that may be implemented in any embodiment.
Fig. 22 shows example lateral response outputs from a sensor comprising an active tuned resonant circuit and a read-out electronic circuit as a passive tuned resonant circuit is displaced laterally relative to an active tuned resonant circuit, such as in the X direction of Fig. 9, wherein the lateral response correspond respectively to different axial separations.

### DETAILED DESCRIPTION

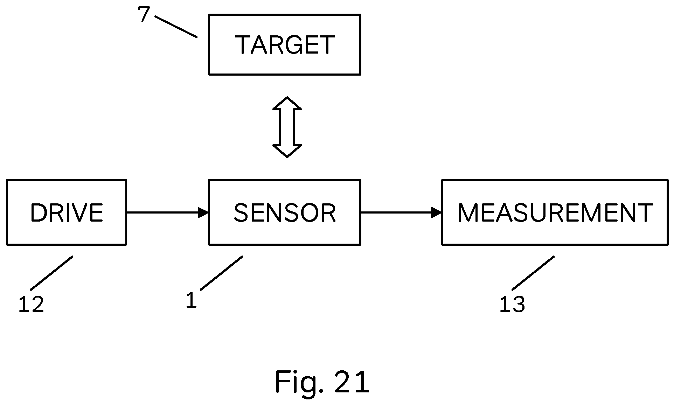

At a general level, Fig. 21 shows an example sensing system that may be implemented in any embodiment, the system having a target 7 and a sensor 1. Preferably, the sensor receives a drive signal or waveform from the drive unit 12, and outputs a signal to the measurement unit 13.

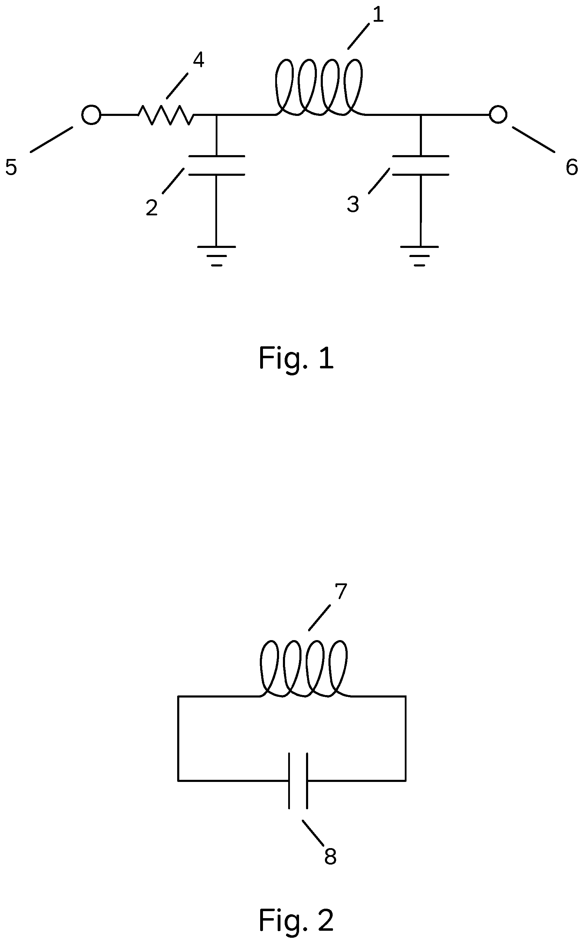

In this regard, Figs. 1 and 2 show, respectively, example active and passive circuits of a resonant sensor, wherein the passive circuit is to act as a load on the active circuit. At least the active circuit comprises a resonant circuit (otherwise known as a tank or tuned circuit) having an inductive coil and configured to resonate with a resonant frequency f_{R}. Preferably, the active and passive circuits are resonant circuits tuned to resonate at a resonant frequency f_{R} in common. The active circuit may comprise a sensor in the form of sensing element for emitting an RF signal, such as the sensing inductive coil 1 of Fig. 1. The passive circuit comprises a target in the form of target element(s) comprising at least one electrically reactive element such as a load inductive coil 7. The active circuit may be excited by a drive signal from a driver (drive electronics) 12, to output from the sensing element(s) an RF signal that is inductively coupled to the target element(s) of the passive circuit. The drive signal generally has a frequency substantially (e.g., exactly) equal to a resonant frequency f_{R} of the active and/or passive circuit.

**In** embodiments, the passive circuit is configured such that variation of position, e.g.,, proximity, of a target element 7 relative to at least one sensing element of the active circuit causes a change in state of at least one of the active and passive circuits. The change may comprise a change of amplitude and/or frequency of resonance of the circuit, and/or a change of quality factor of a tuned circuit of the circuit. The relative position (e.g. proximity) and/or movement (e.g., displacement, speed or velocity) of sensing elements (generally, one such element) of the active circuit and target elements (generally, one such element) of the passive circuit may be sensed by detecting any such changes. A measurement circuit, which may in embodiments be referred to as 'read-out electronics', may detect a variation of a resonant signal output by the active circuit (and/or such a signal output by the passive circuit), to provide a digital or analogue indicator representing the relative position and/or movement.

Notably, a single sensor may detect movement and/or position in different directions of relative movement of the sensing and target elements. In embodiments, the different directions are substantially perpendicular, for example axial and non-axial (e.g. lateral). The measurements for the directions may be based on state changes of the active and/or passive circuits generated at respective, different times. However, in some embodiments they may be generated simultaneously as outlined below.

Some embodiments may have multiple such active resonant circuits that transmit to a shared or respective passive circuit(s) of one or more position/movement sensors within a system. For example, this may provide active resonant circuits for respective actuators such as keys of a keyboard. Alternatively or additionally, such multiple circuits may provide redundancy in respect of each sensor of a system, for example to improve reliability, strength and/or accuracy of an overall measurement signal from a sensor on a respective actuator. The active circuits may be driven using a single drive circuit in common (optionally using a multiplexer to selectively the circuits), and/or may use a multiple to allow use of a single measurement circuit, e.g., read-out circuit, in common.

A preferred sensor embodiment has - instead of for example a single active circuit with one inductive coil 1 as shown in Fig. 1 - an 'interleaved pair' of active resonant circuits. Such a pair is generally referred to herein as an 'active sensor pair'. A single sensor having such a pair may allow simultaneous detection/sensing of movement and/or position in different directions - preferably axial and non-axial - of relative movement of the active sensor pair and target element(s) of the passive circuit.

A sensor having such an active sensor pair may provide advantages when applied to an actuator that is moveable in more than one direction or dimension, e.g., not only axially (e.g., vertically, or up and/or down) but also laterally (e.g. horizontally, sideways, or left and/or right). The sensor may enable position (e.g. proximity) and/or movement (e.g., displacement, speed or velocity) sensing in each direction. Such sensing in axial and non-axial directions may be referred to as 2-dimensional sensing.

An actuator to which a sensor embodiment can be applied may be a musical key. The sensor may then enable a musical effect such as a vibrato effect, based on detection of axial and/or non-axial movement of the key, wherein the non-axial movement may depend on a user's varying sideways contact, force and/or pressure to the key. For example, if the actuator is a piano (acoustic and/or electronic) key, detection of lateral movement may enable a vibrato effect to be generated electronically when a pianist applies lateral force and/or pressure to the key. This may be in addition to the normal effect of causing a respective note to be played when the key is struck by the user. The vibrato effect (generally, subtle and approximately regular variations of pitch similarly as often generated on bowed string instruments, e.g. violin) may be controlled according to a varying such lateral force / pressure, and/or may be an effect that is triggered by an instantaneous detection of such lateral force/pressure. More generally however, embodiments of the multi-dimensional position and/or movement sensing may be applied to any actuation system, musical or otherwise, including to various musical and non-musical actuators, for example a musical effects pedal or a computer key such as for computer gaming.

Merely as a precaution regarding the above terms such as 'axial' and 'lateral', it is emphasised that these do not imply any particular orientation of an actuator, e.g. key. Generally, an axial direction is one in which a moveable member of an actuator or key is movable, e.g., when struck or pushed, by a user (directly or indirectly, e.g., using a tool such as a stick or hammer) such that a gap, e.g., shortest distance, between the moveable member and an opposing (fixed or moveable) member reduces. For many applications, such as a piano or computer key, movement in such an axial direction may generally be considered to be vertical, up or down, and movements in a lateral direction may be considered to be horizontal, left or right. However, in other applications, including other musical instruments such as an accordion, the terms 'axial' and 'lateral' may be purely relative, e.g., merely meaning substantially perpendicular to each other. **In** the specific case of a piano, if a single key was configured to move laterally, the movement may be: sideways over the fixed keybed that is under the full set of keys, the keybed forming a fixed opposing member in relation to every piano key; and/or forwards or backwards, i.e., towards or away from the pianist or the main body of the piano case that holds the strings.

**In** the above-mentioned preferred embodiment comprising an active sensor pair, the pair of active resonant circuits has sensing inductive coils that are interleaved. This may enable a multidimensional, e.g., X and Y, sensor. Each of the active resonant circuits having one of the interleaved coils may be operated independently, such that respective position and/or movement measurement signals are obtainable preferably simultaneously. Regardless, the measurements from the pair may be combined, for example by a processor, to provide a two-dimensional (e.g., x and y) position and/or movement measurement result.

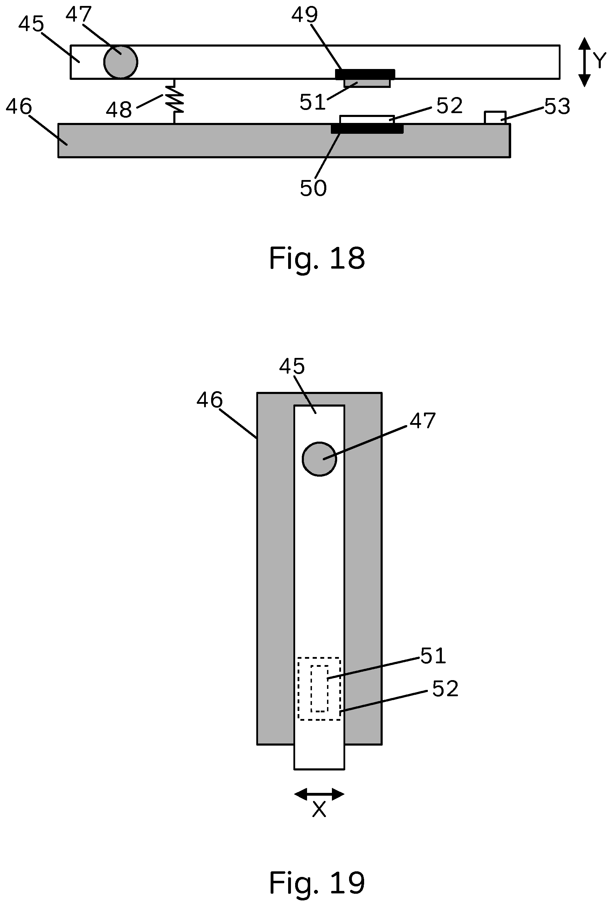

An example actuator incorporating such a multi-dimensional position and/or movement sensor is shown in each of Fig. 18 and Fig. 19, which are consistent with such an actuator in the form of a piano key. The actuator comprises a moveable (e.g., top) member 45 that is rotatable about a pivot preferably at pivot point 47. The moveable member may resist movement by means of a bias 48 such as a spring or other mechanical linkage. The actuator may further comprise a fixed (e.g. bottom) member 46. (Alternatively, either or both of the members 45 and 46 may be moveable, e.g. member 45 may be fixed). At least one deformable end-stop 53 may be provided to limit movement of a respective moveable member. Moreover, the actuator has a position and/or movement sensor comprising an active circuit group 52 (wherein 'group' means one or more) comprising at least one active resonant circuit. The group preferably comprises at least one active sensor pair as discussed above. The sensing element(s) of the group 52 are each inductively coupled to the target element(s) of a passive circuit 51, such that each active resonant circuit provide an output signal that varies as the mutual separation of the active group and passive circuit (e.g., between sensing elements of the active group and target element(s) of the passive circuit) is varied. A driver (drive electronics) 12 (e.g. a Drive unit as illustrated in Fig. 21) may be connected to drive each active circuit. Measurement circuitry / block 13 (e.g. a Measurement unit as illustrated in Fig. 21), which may be read-out electronics, may comprise measurement circuits each connected to receive an output from a respective active and/or passive circuit. Additionally or alternatively, a measurement circuit 13 may connected via a multiplexer and/or switches to receive outputs from multiple active and/or passive circuits, wherein the active circuit(s) belong to the active circuit group, preferably active sensor pair. A pivot, e.g., around point 47, may allow the moveable (e.g. top) member 45 to move in at least two dimensions, shown for purposes of illustration as X and Y.

(It is further noted that, in embodiments such as described above in relation to Figs. 18 and 19, the passive circuit 51 (target) and active circuit group 52 may be respectively provided on the members 45 and 46 or vice versa. Furthermore, it is noted that sensor embodiments, such as a sensor described above in relation to Figs. 18 and 19, may advantageously be retrofittable to an existing actuator, e.g., to an existing piano key or keyboard).

Considering an above-mentioned active sensor pair in more detail, the paired active tuned resonant circuits may each comprise: capacitive element(s) such as an input capacitive element 2 and/or an output capacitive element 3; and inductive element(s) such as a sensing inductive coil 1. Either or both of the active circuits may further comprise an input resistive element 4. A driver 12 comprising one or more driver circuits may be connected to an input line 5 (e.g., terminal or port) of each active circuit of the group/pair. The driver may be configured to selectively enable or inhibit driving of each active circuit of one or more active circuit groups such as the active sensor pair. Each active resonant circuit may therefore be in an idle or driven state according to a drive control signal received from the driver 12. Measurement circuitry 13 may be connected to an output line 6 (e.g., output terminal or port). Further regarding optional features, the input resistive element 4 may for example be omitted, however its presence may in embodiments (i) limit the current supplied to an active tuned resonant circuit from drive electronics; and/or (b) increase the sensitivity of position and/or movement detection when the measurement circuitry is connected to an active tuned resonant circuit. Such current limiting may in turn reduce the operating current, and thus may in some embodiments reduce power consumption and/or electro-magnetic emissions from active tuned resonant circuit.

Referring to Fig. 2, the passive circuit comprises reactance in the form of an inductive coil 7 and preferably a capacitive element 8. The inductive coil and capacitive element may be connected to form a closed resonant LC circuit, otherwise known as a tank circuit. The passive tuned resonant circuit then has resonant frequency *f_{R}* that is dependent on the reactance values of the inductive coil 7 and capacitive element 8.

**It** is preferable to tune the frequency of resonance of the or each active tuned resonant circuit to be close to, or equal to, the frequency of resonance of the passive tuned resonant, *f_{R}*, by corresponding selections of reactance values of the sensing and target elements:, for example, the reactance values of the input capacitive element 2 and/or output capacitive element 3, and sensing inductive coil 1. It is not necessary for the size or the inductance value of the inductive coils 1 and 7 to be equal or even similar.

The driver/electronics 12 may provide an oscillating voltage drive waveform to the or each active circuit, preferably at a frequency equal to or close to a resonant frequency *f_{R}* of the active circuit and preferably also such a frequency of the corresponding passive circuit. The waveform may be a sinusoid, square waveform or pulse-train, generated for example by a microcontroller timer or a digital or analogue timing circuit.

When an active circuit such as that of Fig. 1 is driven by such a driver/electronics 12, the signal amplitude at the output line 6 may decrease as the distance between the active circuit, e.g. sensing inductive coil 1, and the target element, e.g. inductive coil 7 of a corresponding passive circuit, decreases. The decrease of the output line signal from the active circuit may occur because more energy is coupled from the sensing element into the target element, e.g., inductive coil, of the passive circuit. Such coupled energy may be dissipated by the passive circuit.

**In** embodiments where a member, such as a moveable (e.g. top) member 45 or a fixed (e.g. bottom) member 46, of an actuator comprises an electrically conductive material, an electrically insulating spacer 49 or 50 (e.g. air gap ), comprised of a non-conductive material may be interposed between the electrically conductive material and any one ore more electrically reactive element(s). Such electrically reactive element(s) may comprise target element(s) 7 of a passive circuit 51 or sensing element(s) 1 of an active circuit group / pair.

The measurement circuitry 13, e.g., read-out electronics, may have at least one measurement circuit to generate a measurement signal having a voltage proportional to a property, e.g., amplitude, of signal received from a passive or active circuit. Such a received signal may for example be from an output line (e.g., terminal or port) 6 of an active resonant circuit as shown in Fig. 1. The measurement circuitry 13 may further comprise an analogue-to-digital converter 43 to convert the measurement signal to a digital value. At least part of the measurement circuitry 13, e.g., a demodulator and/or analogue-to-digital converter, may be shared, e.g. by multiplexing and/or using switches, between multiple active and/or passive circuits such as active resonant circuits of one or more active circuit groups (e.g. pairs). Passive circuits and/or active circuit groups that share the circuitry 13 may correspond to respective actuators, e.g., keys of a keyboard.

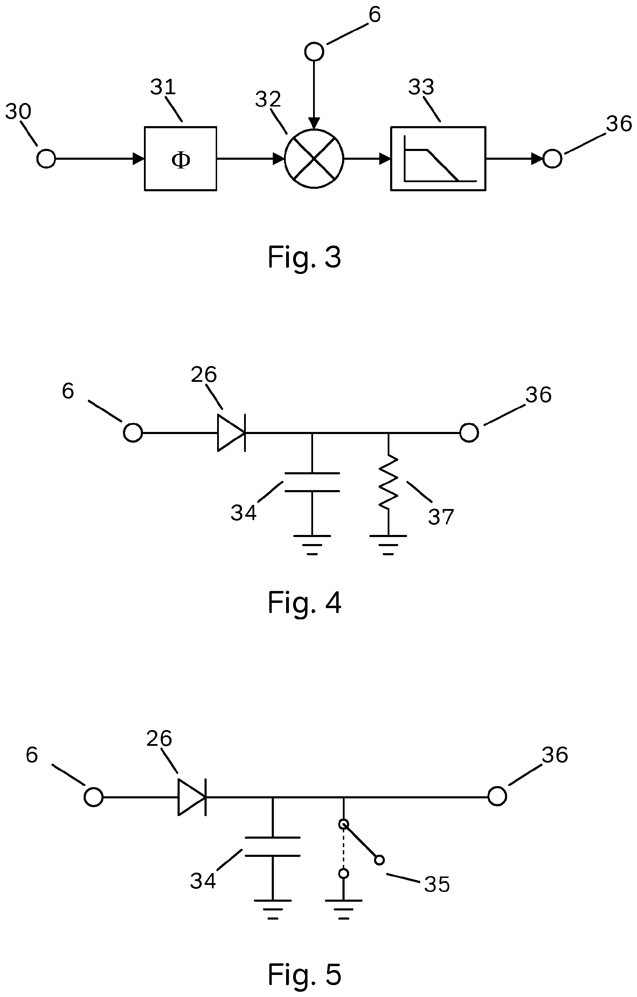

One configuration for the measurement circuitry 13, e.g. read-out electronics, comprises a synchronous demodulator circuit. An example such demodulator circuit, as shown in Fig. 3 demodulates an output signal from an active circuit's output line (e.g., read-out port) 6 by means of an analogue switch or multiplier 32. The switch or multiplier 32 is in turn controlled by a drive waveform received on the demodulator input line 30, wherein the phase of the drive waveform is preferably adjusted by a phase shifting element 31. This demodulation may result in a measurement signal in the form of a low-frequency (or even DC) voltage being presented at demodulator output line 36, preferably via a low-pass filter 33.

An other configuration for the measurement circuitry 13 comprises an amplitude-sensitive demodulator circuit. The example such demodulator circuit of Fig. 4 rectifies an output signal from an active resonant circuit's output line (e.g., output or read-out port) 6 by means of a diode 26. The diode forms a peak-hold circuit with a capacitive element 34 and a resistive element 37. The peak-hold circuit outputs a measurement signal on the output line 36. The time-constant of said peak-hold circuit may be determined by or dependent on the capacitance of the capacitive element 34 and the resistance of the resistive element 37.

Regardless of the type of demodulator used by the measurement circuitry 13, it may be advantageous to reduce a power level (absolute or relatively) of some or all frequency components of the drive signal on the output line 36. Such a reduction is preferably to below a preferred maximum or threshold level for the desired practical application of the position and/or movement sensing system. The frequency components preferably comprise components that are equal to or close to a resonant frequency *f_{R}* of an active circuit connected to the demodulator. This may be achieved by configuring the low-pass filter 33 in Fig. 3, or the peak-hold circuit of Fig. 4, to have a time constant suitable for such level reduction. The power reduction may be advantageous in embodiments where such frequency components may otherwise introduce errors in the measurement signal presented on the output line 36. On the other hand, such a time-constant is preferably small enough to allow rapid variations in sensor-to-target separation to be measured, according to any desired performance criteria of the practical application . Therefore, in some embodiments, selection or determination of demodulator time-constant(s) may involve a compromise between minimising measurement error by reducing the level of frequency components of the sensor drive signal and maximising the speed of response of the position and/or movement sensing system measurement. To reduce the measurement error to about 1% in some embodiment, the time constant is preferably large enough to reduce drive frequency components by about 40dB or more.

An other configuration for the measurement circuit 13, e.g., read-out electronics, comprises a sample-and-hold circuit. **In** the example sample-and-hold circuit of Fig. 5, the output signal from the active resonant circuit's output line 6, e.g., read-out port, is rectified by a diode 26 that forms a peak-hold circuit with a capacitive element 34. The voltage on the capacitive element 34 is held while switch 35 is controlled to be open, and the held voltage may represent a measurement signal on output line 36. At the end of a measurement period, the switch 35 may be closed to discharge the capacitive element 34, and the switch 35 is later opened to begin a new measurement period.

The inductive coils 1 and 7 used in the active and passive circuits respectively can be of any type. However, planar spiral coils may be preferred, for example wherein the windings of such coils are formed by printed tracks such as on a printed circuit board (PCB). **In** embodiments, such coils or tracks may provide any one or more advantages such as: reduced cost; highly reproducible values of inductance; and/or the PCB may also be used to mount other components, such as the capacitive elements 2, 3 and/or 8, and/or the resistive element 4. Advantageously, it may be possible using such planar coils to provide a plurality of inductive coils, in respective active and/or passive circuits, whose inductance values are closely matched. (It is further noted that each spiral may have any suitable formation such as square, circular, hexagonal or octagonal).

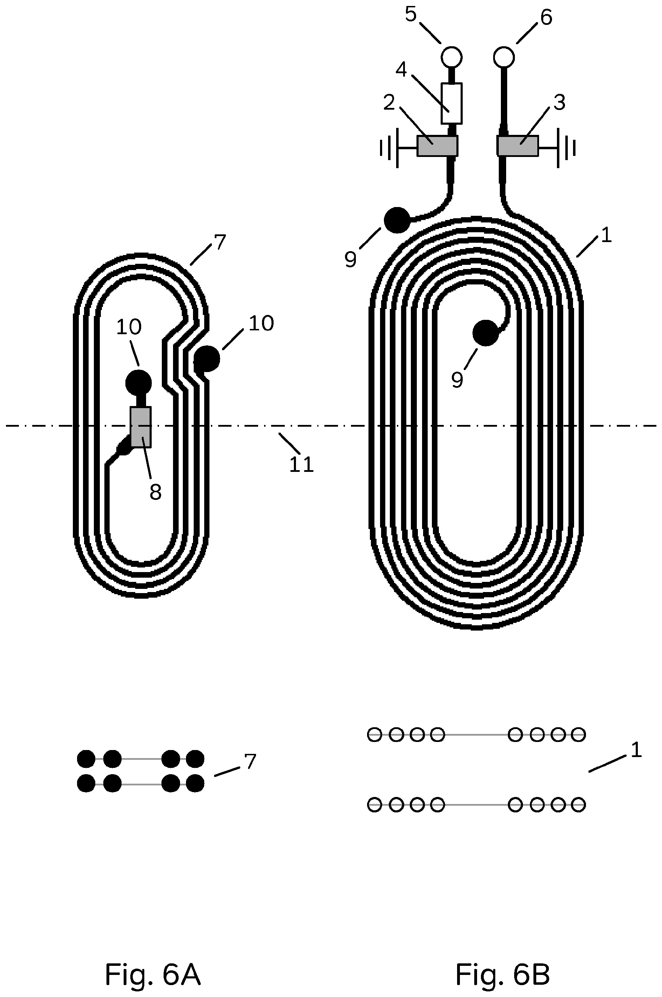

Referring to Fig. 6B, at least a sensing element of an example active tuned resonant circuit may be formed on a PCB comprising one or more electrically conductive layers. As shown, the sensing element may be in the form of an inductive coil 1 comprising a continuous spiral track on a first such layer. Such a spiral track may be electrically connected through connecting via(s) 9 and optional connecting wire(s) to one or more further spiral tracks on other conductive layer(s) of the PCB. This is shown in the lower drawing of Fig. 6B, wherein the lines represent different layers of a PCB and each circle represents a respective cross-section of a track forming the coil 1. Capacitive elements 2 and/or 3, and/or resistive element 4, may be mounted on the PCB and/or are preferably closely or proximally located to the spiral track(s) of the inductive coil 1. The input line (e.g. terminal or port) 5 and/or output line (e.g. terminal or port) 6 of the active circuit may be provided on the PCB for connection to a driver 12 and measurement circuitry 13, e.g., read-out electronics, respectively. The above-mentioned lower drawing of Fig. 6B is a simplified schematic representation of such a sensing inductive coil 1 formed from spiral tracks on two layers of a PCB, wherein the coil viewed as a cross-section through a plane 11. In this example, the two spiral tracks may be on opposite external surface layers of a PCB. However, other embodiments may comprise spiral track(s) on internal and/or external layers of a multi-layer PCB.

However, while it may be preferable to use printed tracks for any or all inductive coil spirals, neither this nor any use of a PCB is essential in any embodiment described herein. We further note that any coil may in embodiments comprise one or more a wire-wound windings instead of, for example, multiple connected PCB track spirals.

Similarly, and referring to Fig. 6A, at least a target element of an example passive (preferably tuned resonant) circuit may be formed on a PCB comprising one or more electrically conductive layers. As shown in the figure, a target element in the form of an inductive coil 7 may be formed of a continuous spiral track on a first such layer. Such a spiral track may be electrical connected through connecting via(s) 10 and/or connecting wire(s), preferably to one or more further spiral tracks on other conductive layer(s) of the PCB. This is shown in the lower drawing of Fig. 6A, wherein the lines represent different layers of a PCB and each circle represents a respective cross-section of a track forming a spiral of the coil 7. The capacitive element 8 may be mounted on the PCB and/or is preferably proximally / closely located to the spiral track(s) of the inductive coil 7. The above-mentioned lower drawing of Fig. 6B is a simplified schematic representation of such an inductive coil 7 formed from spiral tracks on two layers of a PCB , viewed as a cross-section through a plane 11. In this example, the two shown spiral tracks may be on opposite external surface layers of a PCB. However, other embodiments may comprise spiral track(s) on internal and/or external layers of a multi-layer PCB.

Following the above discussion of circuit configurations of multi-directional sensors, the below discussion concerns more specifically variation of sensor outputs, dependent on varying axial and non-axial, preferably lateral, separation between sensing and target elements.

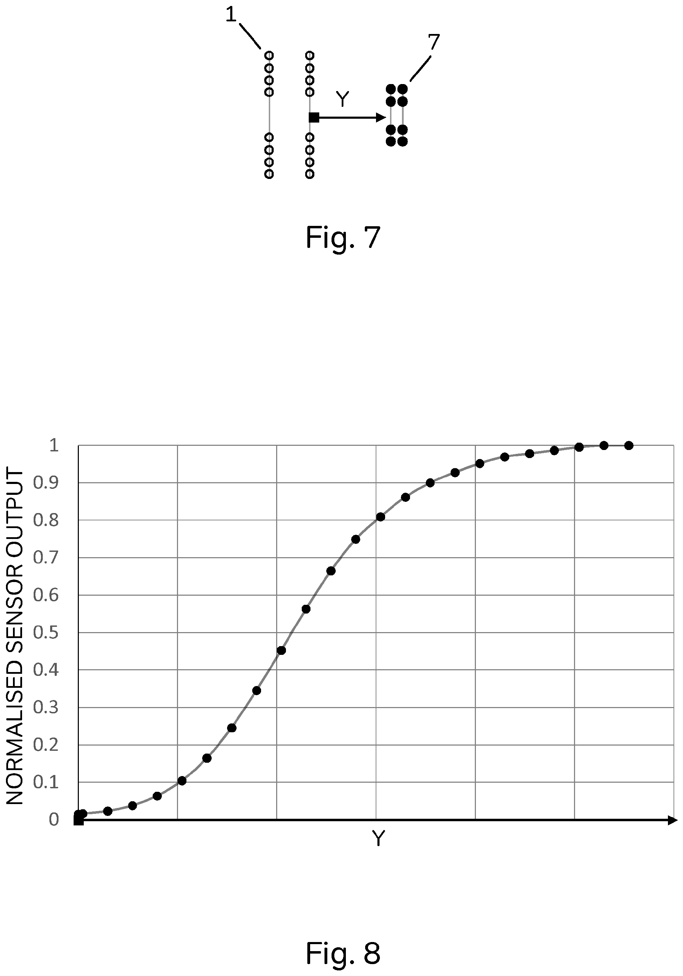

Fig. 7 shows an axial separation as being along a 'Y' direction, wherein 'Y' is used to denote an axial direction between a target element in the form of an inductive coil 7 of a passive circuit (in this example, a passive tuned resonant circuit) and a sensing element in the form of an inductive coil 1 of an active tuned resonant circuit . A corresponding response characteristic is shown in Fig. 8. Similarly to Figs. 6A and 6B, each of the inductive coils 1 and 7 is shown in Fig. 7 as having a configuration comprising multiple planar spirals on respective layers. However, other configurations for example having a single planar spiral in each such coil may achieve a response characteristic similar to or the same as that shown in Fig. 8.

(The cross-sections of the sensing and target element coils 1 and 7 of active and passive circuits respectively are shown on the left and right sides of Fig. 7 merely as an illustrative example. Similarly, the line having a single arrow-head indicates an example Y-direction movement corresponding to decreasing axial separation (such separation indicated on the horizontal graph axis of Fig. 8), however an axial movement of a moveable member may be e.g. upwards or downwards. Furthermore, such axial movement may be relative if both members are moveable axially towards and/or away from each other).

More specifically, Fig. 8 shows an example response characteristic of a normalised sensor output from a measurement circuitry 13 (e.g., read-out electronics), wherein response levels are shown on the vertical, or y-, graph axis of Fig. 8, and axial separation is shown on the horizontal, or x-, graph axis. In embodiments, the characteristic generally follows an S-shaped curve, wherein the sensor output is at a minimum level (e.g., exactly or substantially zero), when the target element in the form of an inductive coil 7 and a sensing element in the form of the inductive coil 1 have a small axial separation. (Such a small separation may be a substantially zero gap thickness, if opposing actuator members having the sensing and target elements are touching). The characteristic is generally at a higher, e.g., maximum, level when the sensing and target elements have a large separation. Notably, in Fig. 8 there is a region between the higher / maximum and lower / minimum levels where the response characteristic is substantially linear.

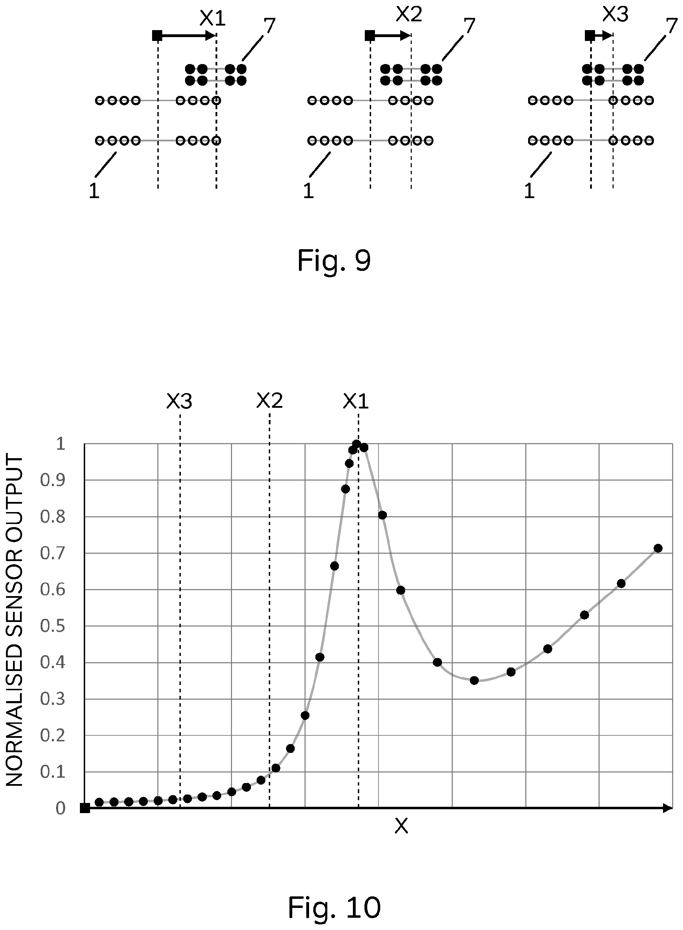

**In** contrast, Fig. 9 illustrates lateral movement along an 'X'-direction wherein 'X' is used to denote a lateral direction (in this example sideways, over or - as specifically shown in Fig. 9 - left-to right) of a target element in the form of an inductive coil 7 of a passive circuit (in this example a tuned resonant circuit) relative to a sensing element in the form of an inductive coil 1 of the active tuned resonant circuit. In this example, the winding of each coil comprises planar spiral tracks (e.g. circular or rectangular), wherein each such track spirals around a gap between opposing sides of track turns of the spiral. Each such gap is shown in Fig. 9 between corresponding sets of filled (or unfilled) small circles that represent track wire cross-sections of a spiral on a respective layer. However, the presence of such a gap is merely preferable; some embodiments may have track cross-sections distributed across the full extent of any spiral.

(Similarly as for Fig. 7, the shown left and right positions in Fig. 8 of the sensing and passive element coils 1 and 7 of active and passive circuits respectively are merely examples. Likewise, each line having a single arrow-head indicates an example X-direction movement corresponding to changing lateral separation (such separation indicated on the horizontal graph axis of Fig. 10). However, a lateral movement of a moveable member may be to or fro, e.g. right to left or left to right. Furthermore, the lateral movement may be relative if both members are moveable sideways towards or away from each other).

Fig. 10 shows an example response characteristic of a normalised sensor output from measurement circuitry 13 (e.g., read-out electronics) coupled to an active coil such as is shown in Fig. 9. Response levels are shown on the vertical, or y-, graph axis of Fig. 10, and non-axial / lateral separation is shown on the horizontal, or x-, graph axis. As described above in relation to Fig. 9, in this example each spiral track has a gap surrounded by the turns of the spiral, such that a spiral cross-section has a set of turn cross-section(s) on each side of the gap. Each set has an inner edge and an outer edge respectively comprising an inner turn cross-section and an outer turn cross-section, wherein 'inner' generally means adjacent a gap and 'outer' corresponds to an outermost turn of the spiral. As further shown in Fig. 9, the spirals of each coil may be substantially aligned, e.g., such that gaps and/or turns of the spirals of a coil substantially mirror each other on either side of an intervening insulating layer.

Regarding the example coils of Fig. 9 having a gap in each coil spiral, the corresponding response of Fig. 10 reveals three notable separation values X1 - X3:
- X1 where a target axis extending through the gap(s) within spiral(s) of the target inductive coil 7 aligns with an outer edge of the sensing inductive coil 1, wherein the outer edge is an outermost edge of a set of winding turn cross-sections on one side of the inductive coil 1. (Preferably, the target axis is a central axis, i.e., an axis of symmetry, through the target coil, which may comprise e.g. a cylindrical or cuboid-shaped coil preferably formed of multiple planar coils);
- X3 where the target axis of the target inductive coil 7 aligns with an inner edge of the sensing inductive coil 1, the inner edge being of the same set of winding turn cross-sections as the afore-mentioned outer edge; and
- X2 where the target axis of the target inductive coil 7 aligns with a sensing axis, which is preferably a central or mid-point axis between the outer edge and the inner edge of the set of winding turn cross-sections of the sensing inductive coil 1.

Further regarding Figs. 9 and 10, when the non-axial / lateral separation of the coils is at or between separations X3 and X1, the response is substantially or exactly monotonic (generally always increasing), and a part or whole of this region is thus preferred for sensing the lateral separation of target and sensing elements such as the inductive coil 7 and said sensing inductive coil 1. However, any other monotonic region of the response characteristic could be used, for example part or whole of the region in Fig. 10 where the sensor output decreases to a minimum from the peak at separation X1, or part or whole of the region where the sensor output increases, with increasing lateral separation, away from the minimum that occurs before separation X1.

Of further interest, the inventor has realised advantage(s) when an active circuit group 52 of the position and/or movement sensor is formed as an above-mentioned 'active sensor pair'. As discussed above, such a pair has active resonant circuits comprising respective, interleaved sensing inductive coils. Thus, a sensing inductive coil 1 of a first active resonant circuit may be interleaved with the sensing inductive coil 1 of a second active resonant circuit. Preferably, and for an embodiment corresponding to Figs. 9 and 10, position and/or movement sensing is limited to a range of relative positions of the active sensor pair and target element, wherein a maximum such range is defined by the target axis (preferably extending centrally through a target coil) being within a region (e.g., a full non-axial / latter extent thereof) where both of the sensing inductive coils overlap. Such a range may be within - or substantially correspond to - the region between separations X1 and X3 for each sensing inductive coil. Thus, to provide a substantially monotonic response, non-axial / lateral position and/or movement sensing is preferably performed within a range of relative positions of the interleaved active pair relative to a target element, wherein the range extends between or within positions wherein respective edges of the overlap region (and thus, in embodiments, gap edges of the respective interleaved coils) align with a target axis.

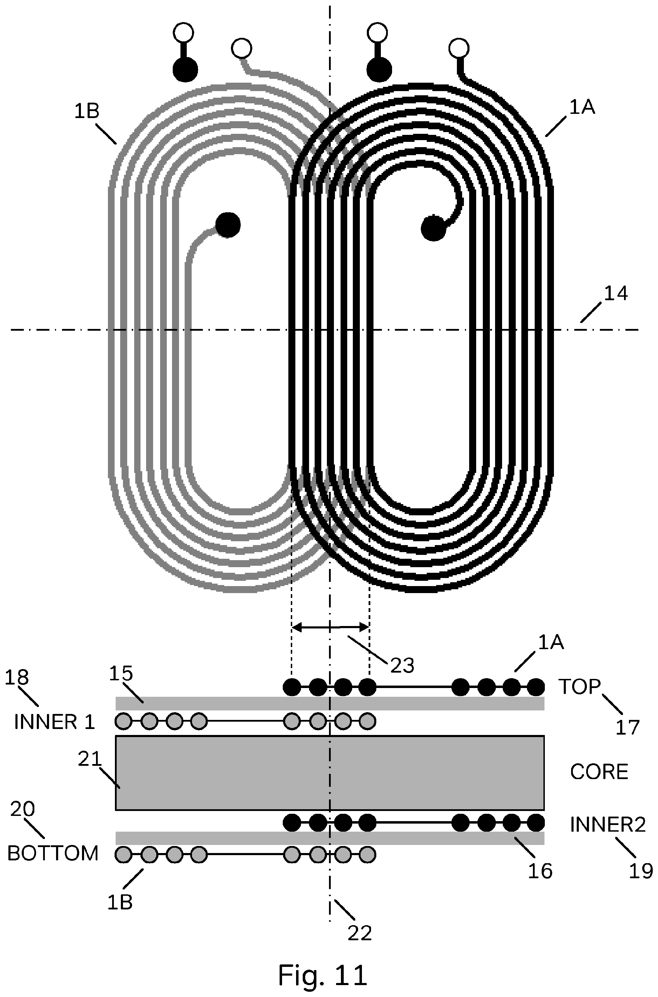

An example practical implementation of such an interleaved pair of sensing inductive coils, using a multi-layer PCB, is shown in Fig. 11. A first sensing inductive coil 1A is formed as a planar coil having a winding comprising spiral(s) in respective conductive layer(s), e.g., 17 and 19, of a multi-layer PCB (e.g., a PCB having four conductive layers). Multiple such spirals on respective conductive layers are preferably connected with via(s) as discussed above. A second sensing inductive coil 1B is formed as a planar coil in other conductive layers, e.g., 18 and 20, of the multi-layer PCB, wherein spirals on respective conductive layers are again preferably connected with via(s) as discussed above. **In** the drawing, the upper conductive layer 17 of the first sensing inductive coil 1A is separated from the upper conductive layer 18 of the second sensing inductive coil 1B by at least a first insulating layer, such as a generally thin first pre-preg layer 15. The lower conductive layer 19 of the first sensing inductive coil 1A is separated from the lower conductive layer 20 of the second sensing inductive coil 1B by at least a second insulating layer, such as a generally thin second pre-preg layer 16. The upper set of layers - in the Fig. 11 example at least comprising conductive and insulating layers 15, 17 and 18 - are separated from the lower set of layers - in the Fig. 11 example at least comprising conductive and insulating layers 16, 19 and 20 - by at least one intermediate insulating layer such as a PCB core material 21.

For a substantially monotonic response in an embodiment as shown in the Fig. 11, position and/or movement sensing is limited to a range of relative positions of target and sensing axes of the target element coil and interleaved coils respectively. With reference to the X1 - X3 separations as shown in Figs. 9 and 10, the range limits for the sensing using the Fig. 11 embodiment may be defined by edges of the overlap region 23 of the planar coils aligning with the target axis, these limits generally corresponding to the regions between X1 and X3 shown in Fig. 9 and Fig. 10. The relative position wherein the preferably central sensing axis 22 of an overlap region 23 aligns with the preferably central target axis, which overlap region is defined by a lateral extent of overlapping turn cross-section sets of the interleaved spirals of the active pair, may effectively correspond to an average of a position for an X2 separation of the first interleaved sensing inductive coil relative to the target and a position for an X2 separation of the second sensing inductive coil relative to the target. Additionally or alternatively, such alignment of the sensing and target axes may correspond to both an X2 separation for the first sensing inductive coil 1A and an X2 separation for the second sensing inductive coil 1B, if those X2 separations can occur at coincident positions of the sensing axis. Consistent with the above discussion of X2 in relation to Figs. 9 and 10, such a sensing axis may be an average of substantially central or mid-point axes of the interleaved sensing coils, each one of those axes being between inner and outer edges of an overlapping sets of winding turn cross-sections of respective interleaved spirals such as of coils 1A or 1B. ('Upper' and 'lower' merely referring to different sides of a PCB core and not implying any particular orientation).

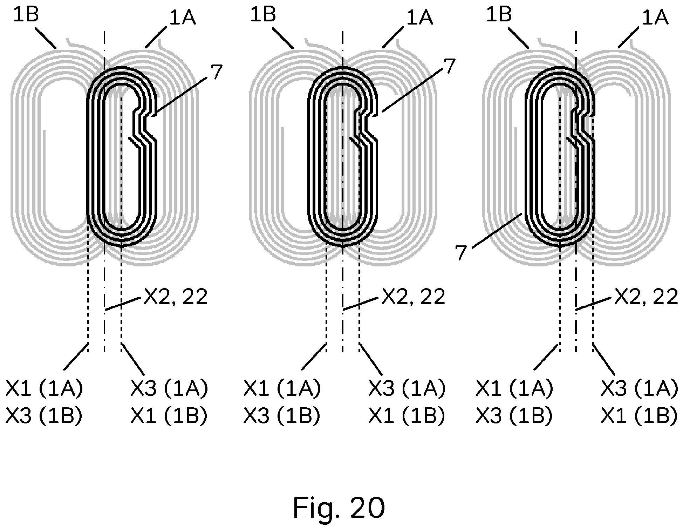

For further understanding of the above, Fig. 20 shows by way of example the target and sensing coil positions for each of the X1, X2 and X3 separations when interleaved coils 1A, 1B such as those of Fig. 11 are used in an embodiment. Note that, in the example of Fig. 20, X1(1A) aligns with X3(1B) because the windings have 100% overlap, the illustrated example thus showing symmetry merely for simplicity. With a smaller overlap, these generally would not align.

Different implementations of the configuration shown in Fig. 11 may be advantageous in one or more ways. The inductance of the first sensing inductive coil 1A may be close to, or substantially match, the inductance of the second sensing inductive coil 1B, for example if the separations between the spirals or layers of each sensing inductive coil (e.g., 17 to 19 and 18 to 20 in Fig. 11) are similar. The active resonant circuits of an active sensor pair may then be closely tuned. Additionally or alternatively, any displacement or movement of the first sensing inductive coil 1A from its position in a reference state relative to the target element may match in magnitude any such displacement of the second sensing inductive coil 1A from the reference position of that coil. Such a reference state preferably corresponds to a zero sensor position or movement. The position of at least one of the sensing coils in the reference state may be central within a preferably limited range of movement of the coil, relative to target element(s), e.g., a preferably central target axis thereof, of a passive (preferably resonant) circuit. Such matching may be improved if for example the thickness of intermediate insulating layer(s) such as PCB core 21 is significantly larger than the thickness of insulating layers such as pre-preg layers 15 and 16. In this way, axial displacement (Y) may be more accurately sensed by using both the first sensing inductive coil 1A and the second sensing inductive coil 1B. In general, it is desirable that the interleaved sensing coils are fabricated to be as identical as possible, including relative to the target element(s). For example, each insulating layer (15 and 16 in Fig. 11) separating the interleaved spirals is desirably thin, such that the interleaved coils have substantially the same effective distance from the target element(s) or target axis. Similarly, a total thickness of the intermediate insulating layer(s) separating pairs of spirals of respective sensing coils, as for example shown in the lower drawing of Fig. 11, is preferably kept as thin as possible.

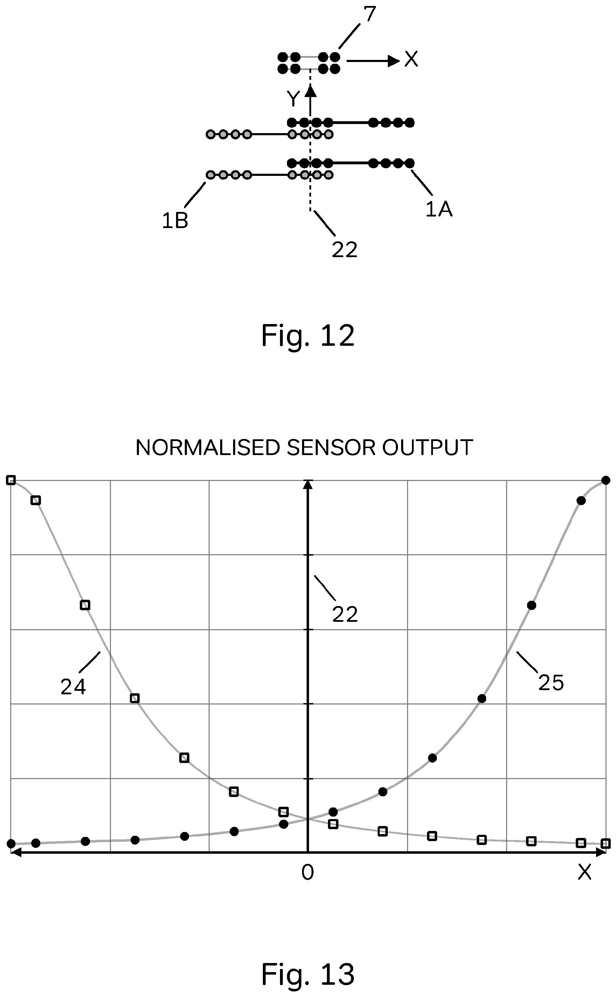

A further or alternative advantage of an interleaved configuration can be understood from Fig. 12. If a target axis, e.g. central axis, of the target inductive coil 7 of the passive (preferably tuned) resonant circuit can move in the lateral or X direction (e.g. left and/or right) relative to the sensing axis 22, e.g., centre line of an overlap region 23, of interleaved spirals of sensing inductive coils of an active sensor pair, and further can move in the axial or Y direction towards and/or away from the interleaved spirals, then a two-dimensional position and/or movement may be obtainable, in embodiments more accurately and/or based on simultaneous output signals. (Any such movement of the target axis may be absolute or relative to the sensing axis; in embodiments it may be the target element and/or the interleaved spirals that actually move). Preferably, the overlap or sensing region 23 is constrained such that the position of the target axis of the inductive coil 7 relative to each of a first sensing inductive coil 1A and a second sensing inductive coil 1B of active sensor pair is within a region that effectively corresponds to a separation value range X1 - X3 as shown in Fig. 9.

Fig. 13 shows an example normalised sensor output from an active sensor pair when a passive tuned resonant circuit is moved laterally in the X direction across the sensing axis 22, e.g., centre line of the overlap region 23 of the interleaved spirals. The position X=0 corresponds to the position of said sensing axis 22. Due to symmetry, the output 24 from the first active resonant circuit of said active sensor pair may be substantially a mirror-image of the output 25 from the second active resonant circuit of said active sensor pair. On the other hand, when the passive tuned resonant circuit is moved axially in the Y direction, as shown in the example response of Fig. 12, the output from both active resonant circuits of the active sensor pair will be modulated for example according to Fig. 8. Thus, it may be possible in embodiments to estimate the Y displacement by summing both of the outputs 24 and 25, and/or to estimate the X displacement by subtracting one of the outputs 24 and 25 from the other. In this regard, it is noted that the output response curves 24 and 25 of the active resonant circuits of the sensor pair are in embodiments generally mirror images of each other as in the example of Fig. 13. Accurate determination of the Y displacement and/or the X displacement may be done by calibration, for example as described below with reference to Fig. 22.

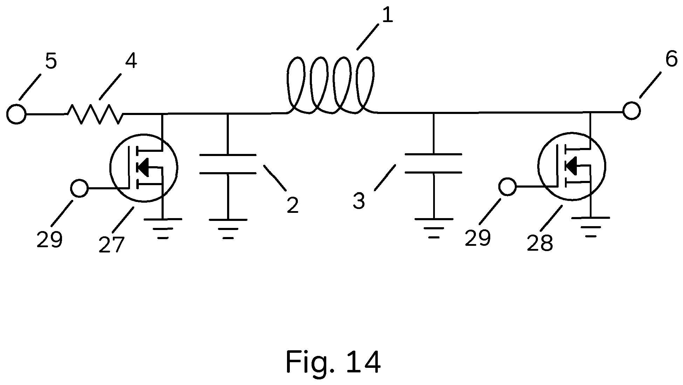

When an active sensor pair, such as shown in Figs. 11 and 12, is operated, there may be interference (crosstalk) between the first sensing coil 1A of the first active resonant circuit and the second sensing coil 1B of the second active resonant circuit. This may occur if, for example , the frequency of resonance of the first active resonant circuit is close to, or equal to, the frequency of resonance of the second active resonant circuit, as may be the case when a single passive resonant circuit 51 is used in the sensor. Such interference may result in the output of the first active resonant circuit and the output of the second active resonant circuit not being independent, thus potentially degrading or preventing accurate determination of the relative X and Y displacements of the active sensor pair and the passive circuit. Tuning the frequency of resonance of the first active resonant circuit to be different, e.g., offset from and/or substantially dissimilar to, the frequency of resonance of the second active resonant circuit may reduce interference. (In embodiment, such a difference may be defined in relation to the width of the resonant peaks, such that the resonant peak of the first active resonant circuit does not overlap with the resonant peak of the second. In this regard, Regarding the 'overlap', it is preferably that the resonant amplitude drops by about 6dB - 12dB (or more) at the point between each respective resonant peak). Additionally or alternatively, interference reduction may achieved using two substantially co-located passive resonant circuits each tuned to a frequency of resonance at, or close to, at least one (preferably each) of the active resonant circuits. (In embodiments, 'co-located' generally means positioned near to each other and attached to a common substrate so that if one target moves, the other moves with it. The windings of each co-located target may be interleaved, or overlap, alternatively they could be side by side). Additionally or alternatively, such reduction may be achieved using drive circuitry operating at two different drive frequencies (one frequency for each active resonant circuit). For some embodiments, the approach shown in Fig. 14 may be more preferable, noting however that the approach may be applied alongside any of above interference reduction technique(s).

Fig. 14 shows a modified active resonant circuit, which may be used to reduce interference between sensing inductive coils of a plurality of active resonant circuits, for example between the respective sensing coils of an active sensor pair such as shown in Fig. 11 or 12. Preferably, mute switch(es) are used in at least one of the active circuits (preferably both in the pair) to controllably mute, i.e., reduce or inhibit resonance and/or RF transmission from the sensing coil(s) of, the active circuit. This may be advantageous where sensing coils are placed very close to each other and/or are self-resonant (i.e., one active circuit may cause resonance in a nearby active circuit). In an example, an input mute switch, e.g., transistor 27, is added to the input of the sensing coil 1. Additionally or alternatively, an output mute switch, e.g., transistor 28, is added to the output of the sensing coil 1. A control line (e.g. terminal or port) 29 is configured to receive a muting control signal. When the active resonant circuit is being driven and intended to resonate, the muting control signal may be set to an inactive state so that no muting transistor mutes the active circuit transmission. On the other hand, when the active resonant circuit is intended to be idle, the muting control signal may be set to an active state that causes at least the output mute transistor 28 to connect to a fixed or DC voltage such as ground (0V), effectively damping the sensing coil 1. **In** embodiments where the active resonant receives a drive signal during such a period when the active circuit is intended to be idle, an input mute transistor 27 may further be provided to connect the input line to a fixed voltage such as ground. The input mute transistor may however be omitted if the drive signal is turned off during each idle period of the active resonant circuit. In such a way, a plurality of active resonant circuits, such as of an active sensor pair, may be operated in close proximity with less or no interference. Such interference reduction may be improved if a low number, preferably only one, of the active resonant circuits of the plurality is active at any given time, preferably by controlled activation output mute transistors, and of drive signal(s) and/or any input mute transistors of the circuits. Further regarding optional features, the input mute transistor may be omitted if for example the value of an input resistor 4 of an active circuit in combination with the output impedance of the driver is low enough that the drive signal, in its idle state, can enable the muting action together with the output muting transistor 28.

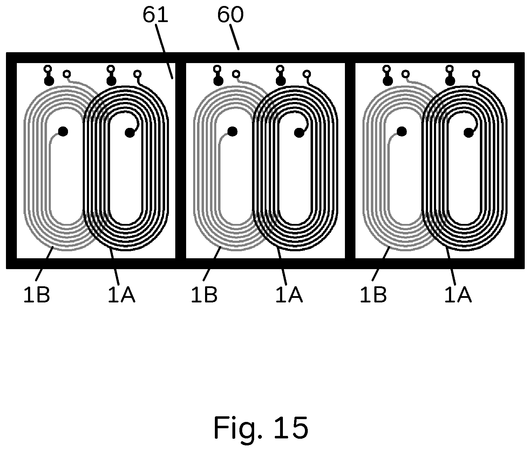

When a plurality of active sensor pairs (1A and 1B) are operated in close proximity, as shown for example in Fig. 15, it can be advantageous to add grounded traces 61 and/or ground planes, preferably on all conductive layers, between each of the active sensor pairs. As shown in Fig. 15, ground traces 61 may be provided between adjacent active sensor pairs, preferably integrated into a ground loop 60 fully surrounding the active sensor pairs such that the ground loops then have shared sections between adjacent sensor pairs. This may reduce interference between each of the active sensor pairs. The inductance of each sensing inductive coil of each active resonant circuit of the active sensor pairs may be better shielded when the grounded traces form continuous loops 60 and 61, around the active sensor pair. Ground traces and/or loops may reduce variances of the inductance of each of the sensing inductive coils, advantageously ensuring that each active sensor pair responds similarly to corresponding passive (preferably resonant) circuits. Such measures may improve sensor performance due to controlled inductance value(s), reduced electromagnetic interference and/or improved isolation of each sensor and/or pair of interleaved coils within a multi-sensor system.

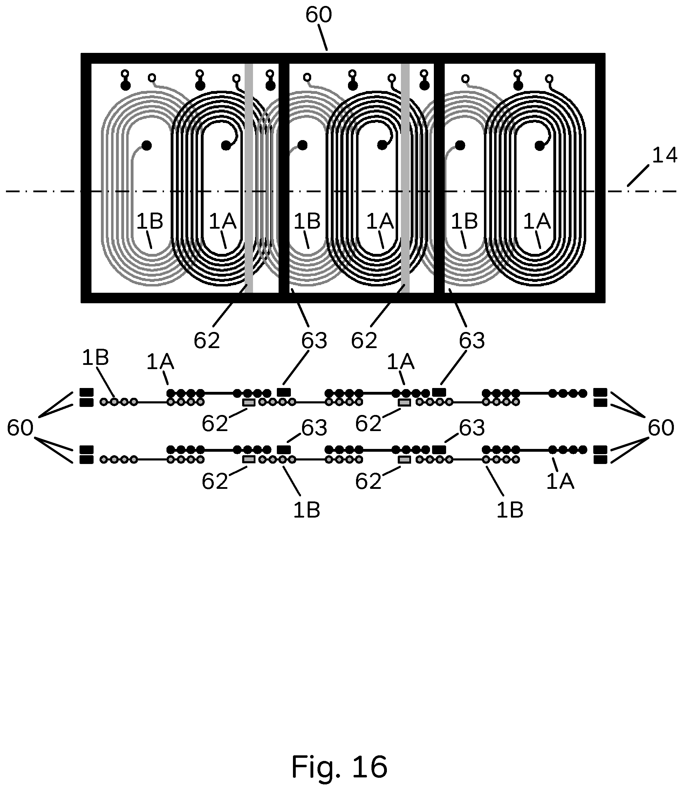

**In** some implementations, a plurality of active sensor pairs may overlap, as for example as shown in Fig. 16, where the pairs are preferably formed on a PCB. (Whereas Fig. 15 shows that ground loops around each active pair are formed by features 60 + 61, in Fig. 16 this is then done by 60+62, or 60+63 to form complete loops around each pair, albeit not on all layers). Such overlapping pairs may be implemented in a system having closely spaced respective actuators, i.e., keys. The sensing inductive coil 1A of at least one active sensor pair overlaps, preferably on different conductive layers of a PCB, the sensing inductive coil 1B of an adjacent active sensor pair . In this case, it may not be possible to add grounded traces 61 as shown in Fig. 15 between each of said active sensor pairs. The inventors have however found that adding ground/ed traces 62 and 63 on at least one layer (preferably of the PCB if used) not occupied by sensing inductive coils may reduce interference between adjacent active sensor pairs, and/or shield the inductance of each sensing inductive coil of each active resonant circuit of the active sensor pairs. As shown in Fig. 16, some layer(s) may each have one or more ground loops comprising traces 60 and 63 between adjacent spirals (on that layer) of the coils 1A, whereas other, intervening layer(s) may each have one or more ground loops comprising traces 60 and 62 between adjacent spirals (on that layer) of the coils 1B. Thus, ground traces and/or ground loops of different layers may overlap as well as the interleaved pairs. Generally, it is preferable that at least immediately or closely adjacent, or overlapping/interleaved, sensing coils are not active at the same time. So 1A and 1B may both be active if they are in different active pairs and so not adjacent, or overlapping. In some embodiments, the active circuits comprising sensing coils 1A are activated alternately to the active circuits comprising sensing coils 1B. Additionally or alternatively, only active circuits having non-adjacent interleaved pairs may be activated simultaneously. In embodiments, selective activation of active circuits may be used to reduce interference and thus improve accuracy and/or reliability of position and/or movement sensing for example among multiple actuators.

Additionally or alternatively to one or more of the above interference reduction techniques(s), a controller may be used. For example, an active sensor pair, or a plurality of active sensor pairs, may include a controller to control selection and/or scanning of each active resonant circuit of the active sensor pair(s) such that adjacent ones of the active resonant circuits are driven at different times. This may in embodiments reduce inter-sensor interference.

**In** some implementations the controller may be configured to time division multiplex operation of the sensors.

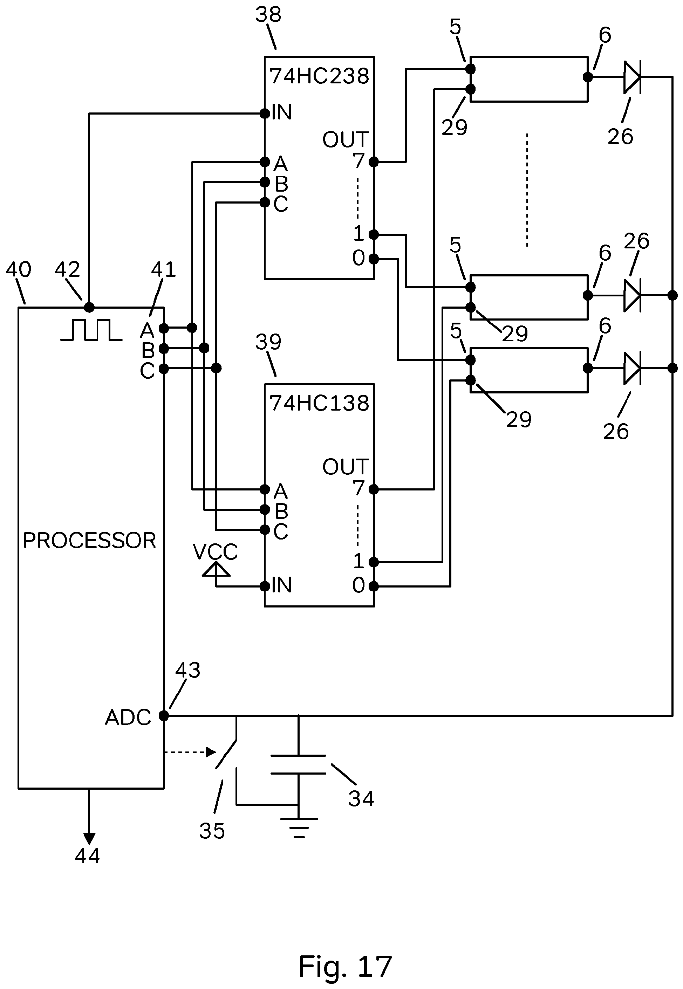

Fig. 17 shows an example time-division multiplexed scheme to multiplex of a group of position and/or movement sensors comprising active resonant circuits according to and/or as described above in relation Fig. 14. Each such circuit has an output mute transistors and preferably further has input mute transistors and/or input resistance 4. Preferably, the circuit operates at a single frequency of resonance. As shown in Fig. 17, the input line (e.g. terminal or port) 5 of each of said active resonant circuits is connected to an output of a first digital demultiplexer 38. The control line (e.g. terminal or port) 29 each of said active resonant circuits is connected to an output of a second, e.g., inverting, digital demultiplexer 39. The output line (e.g. terminal or port) 6 of each of said active resonant circuits is connected to a sample-and-hold circuit (e.g. according to Fig. 5). **In** comparison to Fig. 5 however, while each of the active resonant circuits has an associated diode 26 in Fig. 17, the sample-and-hold capacitive element 34 and/or the sample-and-hold switch 35 may be shared between each active resonant circuit of the group of position and/or movement sensors. The controller may comprise a processor(s) 40 that output preferably one drive signal 42 to the first digital demultiplexer 38 and output a selection signal(s) 41 to the first digital demultiplexer 38 and/or to the second, e.g., inverting, digital demultiplexer 39. An analogue-to-digital converter 43 preferably within a said processor may be connected to the output of the peak-hold circuit. An output 44 from a said processor may send information regarding the position and/or movement of respective said position and/or movement sensor. Using non-inverting and inverting digital demultiplexers (in relation to Fig. 17: 38 and 39 respectively, or vice versa) controlled by the same selection signal(s) may ensure that only one active resonant circuit (or pair of such circuits, in an embodiments using multiple active sensor pairs) in the group of position and/or movement sensors is active during any time-division period; the other active resonant circuits being in the muted state. (Merely for completeness, it is noted that any one or more of the digital circuit blocks above, e.g., demultiplexer 38 and/or 39, can in embodiments be implemented using an analogue equivalent).

The following generally concerns a calibration process for embodiments such as any one of those described above and/or shown in the drawings. In this regard, lateral separation X corresponds to 'x' and axial separation Y corresponds to 'y' in the mathematical annotation below.

In an embodiment suitable for generating a normalised sensor output such as shown in Fig. 13, a region of the output 24 from a first active resonant circuit 1A of an active sensor pair measured according to lateral separation X at a small axial separation (Y = 0) may be described by a smooth lateral response function *f*(*x*)*,* for example a cubic curve 65 as shown in Fig. 22, where: $f \left(x\right) = {ax}^{3} + {bx}^{2} + cx + d$

If the normalised axial response shown in Fig. 8 is denoted as *g(y),* a Y-dependent lateral sensitivity S(y) may be defined, whereby increasing the axial separation y decreases the sensitivity of an active resonant circuit to lateral separation of the passive target: $S \left(y\right) = 1 - g \left(y\right)$

Fig. 22 shows example lateral response outputs 65, 66, 67 and 68 of a first active resonant circuit, for example the sensor 1A as shown in the interleaved configuration of Fig. 12 and having a response outputs such as shown in Fig. 13, as the target separation is varied laterally (along the X axis) at increasing axial (Y) separations, wherein the axial separation Y is smallest for output response 65 and greatest for output response 68. As the axial separation Y increases, the Y-dependent lateral sensitivity S(y) of the sensor to the passive target's lateral separation X decreases, as does the more general sensitivity of the sensor to the target's presence. In this case, an output response as dependent on both of X and Y can in embodiments be described by a function *F(x,y):* $F \left(x, y\right) = f \left(x\right) ∗ S \left(y\right) + D ∗ \left(1-S\left(y\right)\right) ,$ where D is a signal output value at an axial separation, wherein that output and/or separation may be considered to be a maximum output value and a maximum axial separation for the X range under consideration. Such maximum values may correspond to minimum interaction between the active resonant circuit and the passive target. Thus, D is preferably a signal output value that would be output from the active resonant circuit in the absence of the passive circuit or at least in the absence of the target coil. Practically speaking, the maximum value D may never be measured in the presence of the passive circuit or target coil of an embodiment. Therefore, the value of D may be a value determined by measurements during assembly, before the passive circuit or target coil is added to the system under assembly. Alternatively, the value of D may be a predetermined reference value, for example estimated based on experience and/or measurements of related practical implementations of the system.

In an active sensor pair, due to symmetry, the output from the second active resonant circuit may be substantially a mirror-image of the output from the first active resonant circuit and therefore its output may be described by *F(-x, y).*

An approximation of x and y may be obtained by calculating the sum and difference of these sensor outputs, where *sum* gives an approximation of the y position and *dif ference* gives an approximation of the *x* position: $sum = F \left(x, y\right) + F \left(-x,y\right)$ $difference = F \left(x, y\right) - F \left(-x,y\right)$

Although these approximations may be desirable in some applications, they are not fully independent of variations of y. Thus, where significant variations of y are possible, it may be preferred to have a method of determining the x position at any (unknown) y position, described by a function *H(x)* that is not dependent on y.

The inventor has found that one suitable definition of *H(x)* may be derived as follows. The ratio of the *difference* to the *sum* is calculated and expanded as shown below: $\begin{matrix}\frac{difference}{sum} = \frac{F \left(x, y\right) - F \left(-x,y\right)}{F \left(x, y\right) + F \left(-x,y\right)} \\ = \frac{f \left(x\right) ∗ S \left(y\right) + D ∗ \left(1-S\left(y\right)\right) - f \left(-x\right) ∗ S \left(y\right) + D ∗ \left(1-S\left(y\right)\right)}{f \left(x\right) ∗ S \left(y\right) + D ∗ \left(1-S\left(y\right)\right) + f \left(-x\right) ∗ S \left(y\right) + D ∗ \left(1-S\left(y\right)\right)} \\ = \frac{S \left(y\right) ∗ \left(f\left(x\right)-f\left(-x\right)\right)}{S \left(y\right) ∗ \left(f\left(x\right)+f\left(-x\right)-2D\right) + 2 D}\end{matrix}$

The dependence on y (i.e., *S(y))* can be removed by subtracting 2D from the denominator: $\frac{difference}{sum - 2 D} = \frac{\left(f\left(x\right)-f\left(-x\right)\right)}{\left(f\left(x\right)+f\left(-x\right)-2D\right)}$

Thus, a suitable function *H(x)* which is independent of y is: $H \left(x\right) = \frac{difference}{sum - 2 D}$

An advantage of using this method of calibration is that, in embodiments, not only is *H(x)* independent of y, but it also does not depend on the shape of *f*(*x*) or *g(y).* Therefore, any monotonic region of the curve shown in Fig. 8 may be used to represent g(y). Similarly, any monotonic region of the curve shown in Fig. 10 may be used to represent *f*(*x*)*.*

From a measurement of *H(x),* X can be determined by a variety of methods. For example, once *f*(*x*) is determined, X may be determined from an algebraic or numerical solution of *H(x).* Alternatively, *H(x)* may be measured at two or more known X positions and a calibration function (linear or otherwise) created to allow X to be determined from a measurement *of H(x).*

Similarly, once X has been determined, Y can be determined by a variety of methods, for example by calculating Y from an algebraic or numerical solution of *{F(x, y),g(y)}.*

No doubt many other effective alternatives will occur to the skilled person. It will be understood that the invention is not limited to the described embodiments and encompasses modifications apparent to those skilled in the art lying within the spirit and scope of the claims appended hereto.

## Claims

1. A sensing system for detecting position and/or movement, the system comprising:
at least one active resonant circuit each having a sensing coil for emitting an RF signal, each sensing coil comprising a set of at least one turn about an axis; and
a passive circuit having a target coil for receiving RF energy from each said sensing coil, the target coil comprising a set of at least one turn about an axis, wherein, for each said active resonant circuit,:
at least one of the passive circuit and the active resonant circuit is configured to, when the active resonant circuit is driven and the axes of the target coil and sensing coil remain substantially parallel, output a signal dependent on an extent of overlap of the target coil and the sensing coil of the active resonant circuit, to thereby indicate a relative position and/or movement of the target and sensing coils, wherein the indicated relative position and/or movement is substantially within a range of relative positions having at least one limit comprising:
a first relative position wherein a first said axis that is of a first said coil is aligned with an outermost edge of a side of the turn set of a second said coil; and/or
a second relative position wherein the first axis is aligned with an innermost edge on the side of the turn set of the second coil,
wherein the first coil and the second coil comprise the target coil and the sensing coil.

2. The sensing system of claim 1, wherein at least one of:
(i) the axis of the second coil is a second axis extending, preferably substantially centrally, between the inner edge and the outer edge of the turn set of the second coil, the range comprising:
an intermediate relative position wherein the first axis is aligned within the second axis;
(ii) the first axis extends substantially centrally through the turn set of the first coil; or
(iii) the target coil and/or each sensing coil are planar coils each comprising at least one planar spiral.

3. The sensing system of any preceding claim configured to, while the first and second coils face each other with a fixed relative separation in an axial direction, provide a said output signal varying substantially monotonically with a monotonic change of the relative position in a lateral direction that is substantially perpendicular to the axial direction; and
optionally wherein the sensing system is configured to, while the first and second coils have a fixed relative separation in the lateral direction, provide a said output signal varying substantially monotonically with a monotonic change of the relative position in the axial direction.

4. The sensing system of claim 3, comprising at least one measurement circuit to generate a measurement signal indicating a position and/or movement, the at least one measurement circuit configured to:
- generate an axial measurement signal, based on a said output signal varying substantially monotonically with a monotonic change of the relative position in the axial direction at a first time; and
- generate a lateral measurement signal, based on a said output signal varying substantially monotonically with a monotonic change of the relative position in the lateral direction at another, second time.

5. The sensing system of any preceding claim, comprising a sensor having the at least one active resonant circuit and the passive circuit, wherein the at least one active resonant circuit comprises a pair of said active resonant circuits,
wherein each of the pair has a said sensing coil comprising multiple said sets of turns, each said set comprising a spiral,
wherein the spirals of the sensing coils of respective ones of the pair of active resonant circuits are interleaved;
and optionally wherein the interleaved spirals of respective said sensing coils are on opposite sides of an intermediate insulating layer such as a printed circuit board core, wherein:
on a first side of the intermediate insulating layer, a region of a said spiral of a first said sensing coil is between the intermediate insulating layer and a region of a said spiral of a second said sensing coil, the regions of said spirals to thereby overlap; and
on an opposite side of the intermediate insulating layer, a region of another said spiral of the first sensing coil is between the intermediate insulating layer and a region of another said spiral of the second sensing coil, the regions of said spirals to thereby overlap.

6. The sensing system of claim 5, the sensing system comprising measurement circuitry for indicating axial and lateral positions and/or movement, wherein each said lateral position and/or movement is relative between:
- a target axis that is a said axis of the target coil; and
- a sensing axis that is a said axis of a sensing coil of the pair of active resonant circuits, the sensing axis extending, preferably substantially centrally, between the inner edge and the outer edge of an overlap region of the turn sets of the interleaved spirals,
wherein the measurement circuitry is configured to perform the indicating for a range of relative positions of the target axis and sensing axis, wherein the range is within:
- a first relative position wherein the target axis is aligned with a first edge of the overlap region; and
- a second relative position wherein the target axis is aligned with an opposite edge of the overlap region,
preferably wherein the range comprises an intermediate relative position wherein the target axis is aligned with the sensing axis; and
optionally wherein the measurement circuitry is configured to indicate the axial and lateral positions based on said output signals received substantially simultaneously from respective ones of the pair of active resonant circuits.

7. The sensing system of claim 6, configured to generate at least one of:
(i) a lateral position and/or movement indicator by subtracting a said measurement of a said output signal from one of a said pair of active resonant circuits from a said measurement of a said output signal from the other one of the pair; or
(ii) an axial position and/or movement indicator by adding a said measurement of a said output signal from one of a said pair of active resonant circuits from a said measurement of a said output signal from the other one of the pair;
and optionally wherein the sensing system is further configured to generate a two-dimensional position and/or movement indicator based on a said lateral indicator and a said axial indicator, and configured to generate said lateral and axial indicators based on the same said measurements of output signals from the active resonant circuits of a said pair.

8. The sensing system of any one of claims 5 to 7, configured to perform a calibration process and to indicate a relative position and/or movement of the target and sensing coils, wherein the calibration process comprises determining an output response, *F*(*x,y*)*,* of each of the active resonant circuits of the pair, the determined output responses comprising an output response *F*1(*x,y*)*,* of a first of the active resonant circuits and an output response *F2(x, y)* of the other, second active resonant circuit,
wherein at least the determining of the output response *F*1(*x,y*) is a determination procedure comprising:
measuring a said output signal from the active resonant circuit at different lateral separations, x, while axial separation, y, is constant, to thereby generate a lateral response, *f*(*x*);
measuring a said output signal from the active resonant circuit at different axial separations, y, while lateral separation, x, is constant, to thereby generate an axial response, g(y);
determining a lateral sensitivity, S(y), according to *S(y)* = 1 - *g(y);* and
determining the output response, *F(x,y),* according to *F(x,y) = f(x) * S(y) + D ** (1 *- S(y)),* where D is a reference signal output value at an axial separation,
wherein the determining of the output response *F2(x,y)* is based on:
- performing the determination procedure for the other, second active resonant circuit; or
- determining *F2(x,y)* as a reverse response, *F(-x,y),* that is a reversal of *F*1(*x,y*) about *x =* 0,
wherein the indication of the relative position and/or movement is performed by determining:
an approximation of axial separation, y, based on *y = F1(x,y) + F2(x,y);* and/or
an approximation of lateral separation, *x,* based on *x = F*1(*x,y*) *- F2(x,y);* and
optionally wherein the indication of the relative position and/or movement comprises determining the axial separation based on a function *H(x):* $H \left(x\right) = \frac{difference}{sum - 2 D}$
wherein the difference is *F*1(*x,y*) *- F2(x, y)* and the sum is *F1(x, y)* + *F*2(*x*, y).

9. The sensing system of any one of claims 5 to 8, configured to:
drive the active resonant circuits of a said pair one at a time; and/or
operate subsets of multiple said pairs of active resonant circuits one at a time, preferably wherein each said subset is one said pair.

10. The sensing system of any one of claims 5 to 9, comprising conductive layers wherein each said sensing coil of the pair has a said interleaved spiral in a respective said layer, wherein:
at least one of the conductive layers has a ground loop surrounding the interleaved spiral on that layer and a said interleaved spiral of the pair that is in another said conductive layer; and
optionally wherein the interleaved spirals of a said pair of active resonant circuits overlap the interleaved spirals of another pair of active resonant circuits,
preferably wherein each said pair comprises at least one said ground loop surrounding a said spiral of each of the sensing conductive coils of the pair, the group loop in a plane between and not comprising any said spirals of the pair.

11. The sensing system of any one of claims 5 to 10, wherein at least one of:
(i) the active resonant circuits of a said pair have offset resonant frequencies; and/or
the passive circuit comprises a pair of preferably substantially co-located passive resonant circuits each for inductively receiving energy from a respective one of the pair of active resonant circuits, wherein each of the passive resonant circuits has a resonant frequency that is substantially the same as the resonant frequency of each of the active resonant circuits of the pair; and/or
the system is configured to provide drive signals to drive respective active resonant circuits of the pair, the drive signals having different drive frequencies; or
(ii) a said active resonant circuit comprises:
an output mute switch coupled to an output line of the sensing coil; and
preferably an input mute switch coupled to an input line of the sensing coil,
wherein each said mute switch is configured to apply a fixed voltage to the coupled line when the active resonant circuit is undriven and/or is to be idle; and.
optionally wherein the at least one active resonant circuit comprises multiple said active resonant circuits each having a said output mute switch and preferably the input mute switch, the sensing system configured to selectively drive one of the active resonant circuits at a time to emit an **RF** signal, and to control at least a said output mute switch of each undriven active resonant circuit to apply the fixed voltage.

12. An actuator comprising the sensing system of any preceding claim, the actuator having:
a first member having at least the sensing coil of at least one said active resonant circuit; and
a second member having at least the target coil of a said passive circuit,
wherein the first and second members face each other in an axial direction, and
wherein at least one of the first and second members is movable in at least a lateral direction relative to the other of the first and second members, the lateral direction substantially perpendicular to the axial direction,
preferably wherein at least one of the first and second members is movable in the axial direction relative to the other of the first and second members; and
optionally wherein at least one of:
the first member comprises an electrically conductive material and an electrically insulating spacer, such as an air gap, between the electrically conductive material and at least one said sensing coil; and/or
the second member comprises an electrically conductive material and an electrically insulating spacer, such as an air gap, between the electrically conductive material and at least the target coil.

13. A piano key in the form of the actuator of claim 12.

14. A musical instrument having an actuator according to claim 12 or 13; and
optionally wherein the musical instrument is a keyboard comprising a plurality of said actuators;
preferably wherein the target coil and/or each sensing coil are planar coils each comprising at least one planar spiral

15. A method of detecting position and/or movement, the method comprising:
driving an active resonant circuit to emit an **RF** signal from a sensing coil of the active resonant circuit, the sensing coil comprising a set of at least one turn about an axis;
receiving, by a target coil of a passive circuit, energy from the emitted **RF** signal, the target coil comprising a set of at least one turn about an axis;
outputting at least one signal from the active resonant circuit during the **RF** emission, each at least one signal dependent on resonance of the active resonant circuit; and
determining a relative position and/or movement of the target and sensing coils based on one or more said signals that are outputted when a relative position of the target and sensing coils is substantially within a range having at least one limit comprising:
a first relative position wherein a central axis of the target coil is aligned with an outermost turn on a side of the sensing coil; and/or
a second relative position wherein the central axis of the target coil is aligned with an innermost the turn on the side of the sensing coil.
